# EUROPEAN PATENT APPLICATION

(11) **EP 2 175 481 A1**
(43) Date of publication of application: **14.04.2010**
(21) Application number: 08777945.0
(22) Date of filing: 07.07.2008
(51) Int. Cl.: H01L 21/336, H01L 29/786, H01L 51/05, H01L 51/40

(54) **PROCESS FOR PRODUCING ORGANIC SEMICONDUCTOR ELEMENT, ORGANIC SEMICONDUCTOR ELEMENT, AND ORGANIC SEMICONDUCTOR DEVICE**

(30) Priority: 10.07.2007 JP 2007181167
(71) Applicant: Sumitomo Chemical Company, Limited, Tokyo 104-8260 (JP)
(72) Inventor: YAMATE, Shinichi, Tsukuba-shi Ibaraki 305-0821 (JP)
(74) Representative: Nicholls, Michael John
(86) International application number: PCT/JP2008/062283
(87) International publication number: WO 2009/008407

(57) **Abstract**

An object of the present invention is to provide a method for producing an organic semiconductor element allowing depression of electrical properties of active layer to be prevented, moreover allowing an active layer patterned to have a satisfactory pattern shape to be formed. In order to achieve the above object, the method for producing an organic semiconductor element of the present invention has the step of laminating a layered body resulting from lamination of a support film and the active layer to an element substrate on which the active layer will be disposed so that the active layer of the layered body will be in contact with the element substrate, the step of forming a mask having a prescribed pattern shape on the support film's surface located on the side opposite to the active layer, and the step of patterning the active layer by removing the layered body located in a region where the mask has not been formed.

## Description

### Technical Field

The present invention relates to a process for producing an organic semiconductor element, an organic semiconductor element obtained thereby, and an organic semiconductor device provided with this organic semiconductor element.

### Background Art

An organic semiconductor element is an element having an active layer comprising a semiconductor film containing an organic semiconductor compound. As such organic semiconductor elements, for instance, transistors and circuit element or the like can be given as examples, and these are applied to semiconductor devices such as, for instance, displays. When applying an organic semiconductor element to a semiconductor device, it is necessary that an active layer is patterned in a shape that fits the circuit pattern formed on this semiconductor device.

As methods for forming a patterned active layer in an organic semiconductor element, similarly to the case of an inorganic semiconductor element of the prior art, forming of a photoresist layer by coating of a photoresist solution, and, methods by patterning techniques using photolithography and etching, and the like, are used in general (refer to Patent Reference 1 and Non-patent Reference 1). According to these methods, patterning that allows microscopic and satisfactory pattern shapes to be obtained becomes possible.
Patent Reference 1: Japanese Patent Application Laid-open No. 2006-41317
Non-patent Reference 1: H.E.Huitema et al., Adv. Mater., Vol 14, p.1201,2002.

### Disclosure of the Invention

### Problems to be Solved by the Invention

However, in the cases of the above-mentioned prior art methods, there is the problem that the active layer containing the organic semiconductor compound becomes deteriorated by exposure to the solvent in the photoresist solution or the like, decreasing the electrical properties thereof.

In particular, in recent years, in order to obtain high carrier mobility by the active layer, the active layer is conferred a prescribed orientation. However, if patterning is performed by carrying out photolithography or etching or the like on an active layer conferred with orientation, the orientation is sometimes affected. Therefore, careful considerations are necessary so that the photoresist solution employed does not affect the orientation. While the method of providing a protective layer can be considered in order to protect the active layer, in such a case as well, not only a deterioration of the active layer due to the formation of the protective layer but also the influence on the orientation must be considered. Thus, when forming an active layer having orientation, forming a pattern shape that is microscopic and satisfactory tends to be all the more difficult.

Therefore, the present invention was devised in view of such a situation and an object thereof is to provide a method for producing an organic semiconductor element allowing the decrease in the electrical properties of the active layer to be prevented, and furthermore, allowing a patterned active layer to be formed so as to have a satisfactory pattern shape. In addition, it is an object of the present invention to provide an organic semiconductor element obtained by such a production method, and a semiconductor device provided with such an organic semiconductor element.

### Means for Solving the Problem

In order to achieve the above objective, the method for producing an organic semiconductor element of the present invention is a method for producing an organic semiconductor element having an active layer comprising a semiconductor film containing an organic semiconductor compound, the method comprising the step of laminating a layered body resulting from lamination of a support film and the active layer to an element substrate on which the active layer will be disposed so that the active layer of the layered body will be in contact with the element substrate, the step of forming a mask having a prescribed pattern shape on the support film's surface located on the side opposite to the active layer, and the step of patterning the active layer by removing the above layered body in a region where the mask has not been formed.

In such a production method of the present invention, an active layer pre-formed on a support film is laminated to an element substrate and then a mask is formed on the support film to carry out patterning. Therefore, the support film can function as-is as a protective layer for the active layer, allowing damages to the active layer due to mask forming or the like to be reduced. In addition, even when forming an active layer having orientation, the influence on the orientation due to mask forming or the like can also be extremely small owing to the support film above the active layer. Consequently, according to the production method of the present invention, forming an active layer having a microscopic and satisfactory pattern shape becomes possible, in which the decrease in electrical properties or the like due to patterning is extremely small even if it were to be oriented,.

It is desirable that, before laminating the layered body to the element substrate, the method for producing an organic semiconductor element of the present invention described above has a step of orienting the active layer in this layered body. Doing so allows the orientation to be conferred to the active layer in the state of a layered body, for which the degree of freedom of the shape is relatively high, and thus the extent of the orientation is adjusted readily. Then, in the present invention, as described above, given that generation of disturbance in the orientation due to patterning is difficult even if the orientation has been generated in the active layer beforehand, forming an organic semiconductor element provided with an active layer having the desired degree of orientation is all the more facilitated by orienting the active layer prior to laminating.

In addition, in the present invention, it is desirable that the mask is one formed directly on the support film's surface located on the side opposite to the active layer by applying a solution containing a forming material for forming the mask. Doing so allows a mask having a prescribed pattern shape to be formed directly, without having to go through cumbersome processes of the prior art of forming a precursor layer comprising a masking material and further forming a mask thereabove to perform patterning of the precursor layer in order to form the mask, allowing the mask forming step to be simplified.

Note that, in prior art, the active layer containing the semiconductor compound, many being of high solubility in organic solvent, sometimes gives rise to issues such as the active layer becomes dissolved when forming a mask by solution coating, while with the present invention, given that the mask is formed via a support film as described above, there are little concerns such as dissolution of the active layer. As such, the present invention is extremely advantageous for performing mask forming by solution coating, which process is relatively simple, and in addition, has the advantage of allowing a variety of mask layer forming materials to be used.

Note that, as a semiconductor element produced in the present invention, a transistor comprising a source electrode, a drain electrode, the active layer to serve as a current pathway between the electrodes, and a gate electrode that controls the amount of current passing through the current pathway is desirable. Since such transistors (organic thin film transistors) vary greatly in properties according to carrier mobility due to the active layer, it is particularly important to form an active layer which is patterned while minimizing damages. Consequently, the process for producing an organic semiconductor element of the present invention is extremely effective for the production of a transistor having the constitution described above.

In addition, the present invention provides an organic semiconductor element obtainable by the above method for producing an organic semiconductor element of the present invention. Being one that is obtained by the above production method of the present invention, the organic semiconductor element of the present invention is provided with an active layer having small damages and a satisfactory pattern shape, and may be one having excellent carrier mobility.

In addition, the present invention provides a semiconductor device comprising the organic semiconductor element of the present invention. Having the organic semiconductor element of the present invention, such a semiconductor device may readily become one having excellent function.

### Effects of the Invention

According to the present invention, a process for producing an organic semiconductor element can be provided, allowing an active layer to be formed, in which the decrease in electrical properties or the like due to patterning is extremely small even if it were to be oriented, and moreover, having a microscopic and satisfactory pattern shape. In addition, an organic semiconductor element obtained by such a production method, and having high carrier mobility, and, a semiconductor device provided with this organic semiconductor element can be provided.

### Brief Description of Drawings

FIG. 1 is a Schematic cross-sectional view of a transistor according to a first embodiment.
FIG. 2 is a Schematic cross-sectional view of a transistor according to a second embodiment.
FIG. 3 is a Schematic cross-sectional view of a transistor according to a third embodiment.
FIG. 4 is a Schematic cross-sectional view of a transistor according to a fourth embodiment.
FIG. 5 is a Schematic cross-sectional view of a transistor according to a fifth embodiment.
FIG. 6 is a Schematic cross-sectional view of a transistor according to a sixth embodiment.
FIG. 7 is a Process chart showing the process for producing a transistor of the first embodiment.
FIG 8 is a Process chart showing the process for producing a transistor of the first embodiment.
FIG. 9 is a Process chart showing the process for producing a transistor of the second embodiment.
FIG. 10 is a Process chart showing the process for producing a transistor of the second embodiment.
FIG. 11 is a Process chart showing the process for producing a transistor of the third embodiment.
FIG. 12 is a Process chart showing the process for producing a transistor of the third embodiment.
FIG. 13 is a Process chart showing the process for producing a transistor of the fourth embodiment.
FIG. 14 is a Process chart showing the process for producing a transistor of the fourth embodiment.
FIG. 15 is a Process chart showing the process for producing a transistor of the fifth embodiment.
FIG. 16 is a Process chart showing the process for producing a transistor of the fifth embodiment.
FIG. 17 is a Process chart showing the process for producing a transistor of the fifth embodiment.
FIG. 18 is a Process chart showing the process for producing a transistor of the sixth embodiment.
FIG. 19 is a Process chart showing the process for producing a transistor of the sixth embodiment.
FIG 20 is a Process chart showing the process for producing a transistor of the sixth embodiment.
FIG. 21 is a Figure showing the process for producing the transistor of Example 1.
FIG. 22 is a Figure showing the process for producing the transistor of Example 1.
FIG. 23 is a Figure showing the process for producing the transistor of Example 1.
FIG. 24 is a Figure showing the process for producing the transistor of Comparative Example 1.

### Explanation of Reference Numerals

10...Substrate, 12...Gate electrode, 14...Insulation layer, 16...Source electrode, 18...Drain electrode, 20, 24...Active layer, 22...Semiconductor film, 30, 32, 34, 36, 38, 64...Element substrate, 50...Layered body, 52...Support film, 54...Photoresist layer, 56...Mask layer, 60, 62...Second element substrate, 100, 105, 110, 115, 120, 125... Transistor.

### Best Mode for Carrying Out the Invention

Hereinafter, preferred embodiments of the present invention will be described with reference to figures. Note that in the description of the figures, like elements are assigned like numerals, and repeated descriptions will be abbreviated. In addition, the figures have been drawn by exaggerating portions thereof for ease of understanding, and the size ratios do not necessarily match those in the descriptions.

Herein, as an organic semiconductor element, a transistor (organic thin film transistor) is taken as an example, to describe the preferred embodiments for the constitution and production method thereof. As long as it is a semiconductor element that amplifies or switches a current and is one provided with an active layer containing an organic semiconductor compound, it can be applied without particular limitation as this transistor. Bipolar transistors, electrostatic induction transistors, field effect transistors, and the like, may be cited as such transistors.

Then, in the following description, in particular, a transistor provided with a source electrode and a drain electrode, an active layer that is the current pathway between these electrodes and having an organic semiconductor compound, and a gate electrode controlling the current passing through the current pathway, and a production method thereof will be described. As transistors having such constitution those with a variety of structures may be cited such as, for instance, in the case of a field effect transistor, planar type, reverse-staggered type and staggered type.

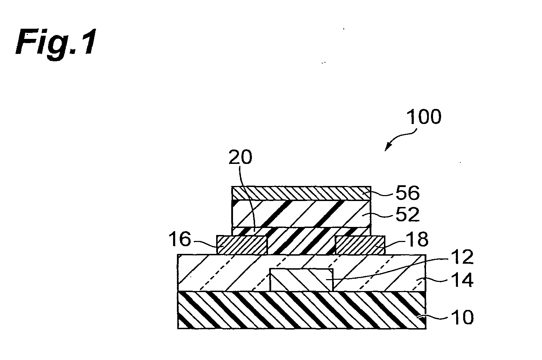

First, the constitution of a transistor the preferred embodiment will be described referring to FIG 1 through FIG 6.

FIG. 1 is a schematic cross-sectional view of a transistor according to a first embodiment. Transistor 100 shown in FIG 1 is one provided with a substrate 10, a gate electrode 12 formed above the substrate 10, an insulation layer 14 formed above the substrate 10 so as to cover the gate electrode 12, a source electrode 16 and a drain electrode 18 formed above the insulation layer 14, an active layer 20 formed above the insulation layer 14 so as to cover portions of the source electrode 16 and the drain electrode 18, a support film 52 formed so as to cover the active layer 20, and a mask layer 56 formed so as to cover the support film 52.

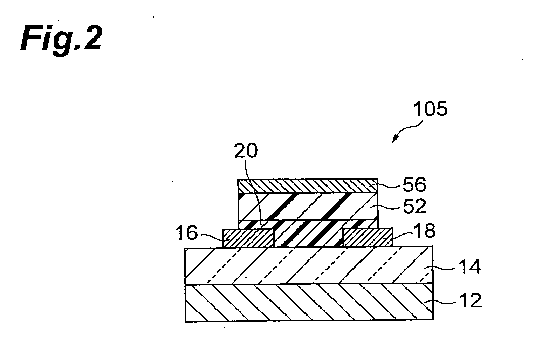

FIG 2 is a schematic cross-sectional view of a transistor according to a second embodiment. Transistor 105 shown in FIG. 2 is one provided with a gate electrode 12, an insulation layer 14 formed above the gate electrode 12, a source electrode 16 and a drain electrode 18 formed above the insulation layer 14, an active layer 20 formed above the insulation layer 14 so as to cover portions of the source electrode 16 and the drain electrode 18, a support film 52 formed so as to cover the active layer 20, and a mask layer 56 formed so as to cover the support film 52. Note that the gate electrode 12 in this transistor 105 is one that combines also the function of the substrate 10 in the transistor 100 of the above first embodiment.

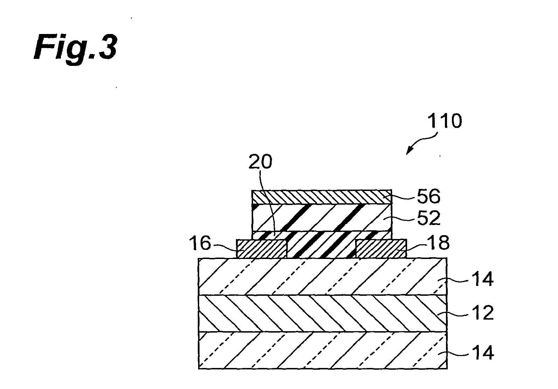

FIG. 3 is a schematic cross-sectional view of a transistor according to a third embodiment. Transistor 110 shown in FIG. 3 is one provided with a gate electrode 12, insulation layers 14 formed on both faces of the gate electrode 12, a source electrode 16 and a drain electrode 18 formed above one insulation layer 14, an active layer 20 formed above the insulation layer 14 so as to cover portions of the source electrode 16 and the drain electrode 18, a support film 52 formed above the active layer 20, and a mask layer 56 formed so as to cover the support film 52. The gate electrode 12 in this transistor 110 is one that combines also the function of the substrate 10 in the transistor 100 of the above first embodiment.

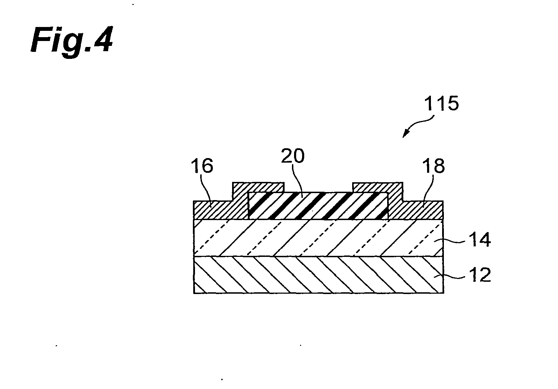

FIG. 4 is a schematic cross-sectional view of a transistor according to a fourth embodiment. Transistor 115 shown in FIG. 4 is one provided with a gate electrode 12, an insulation layer 14 formed above the gate electrode 12, an active layer 20 formed above the insulation layer 14, a source electrode 16 and a drain electrode 18 formed so as to cover a portion of the active layer 20.

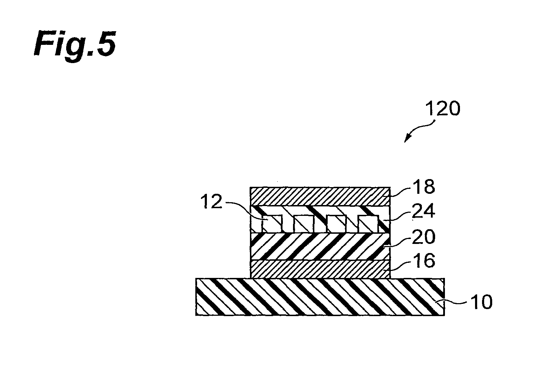

FIG. 5 is a schematic cross-sectional view of a transistor according to a fifth embodiment. This transistor 120 is an electrostatic induction organic thin film transistor. The transistor 120 shown in FIG. 5 is one provided with a substrate 10, a source electrode 16 formed above the substrate 10, an active layer 20 formed above the source electrode 16, gate electrode 12 formed in multiples (here, four) over the active layer 20, an active layer 24 formed above the active layer 20 so as to cover these gate electrodes 12, a drain electrode 18 formed above this active layer 24. In this transistor 120, the two active layers 20 and 24 may be layers that are constituted from the same material, or may be layers constituted from different materials.

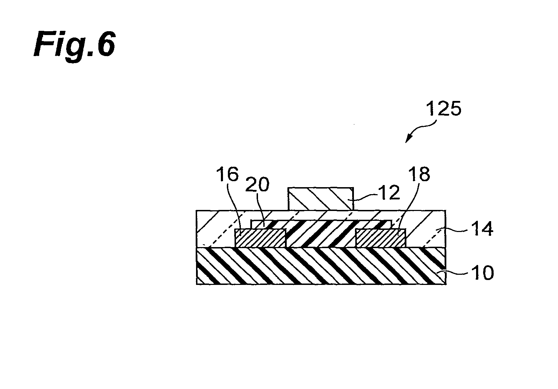

FIG. 6 is a schematic cross-sectional view of a transistor according to a sixth embodiment. This transistor 125 is one provided with a substrate 10, a source electrode 16 and a drain electrode 18 formed above the substrate 10, an active layer 20 formed above the substrate 10 so as to cover portions of these source electrode 16 and drain electrode 18, an insulation layer 14 formed above the active layer 20, and a gate electrode 12 formed above the insulation layer 14.

In all the transistors according to the first to fourth and sixth embodiments described above, the active layer 20 is a layer comprising a semiconductor film containing an organic semiconductor compound, and is a current passage (channel) between the source electrode 16 and the drain electrode 18. In addition, the gate electrode 12 controls the current passing through the current passage (channel) in the active layer 20 by application of a voltage.

In addition, in the transistor according to the fifth embodiment, the active layers 20 and 24 contain an organic semiconductor compound and are a current passage between the source electrode 16 and the drain electrode 18. The gate electrode 12 controls the current passing through the current passage similarly to above.

Hereinafter, the process for producing the transistor of each embodiment described above will be described along with further detailed constitution of the transistors.

### (Process for producing the transistor of the first embodiment)

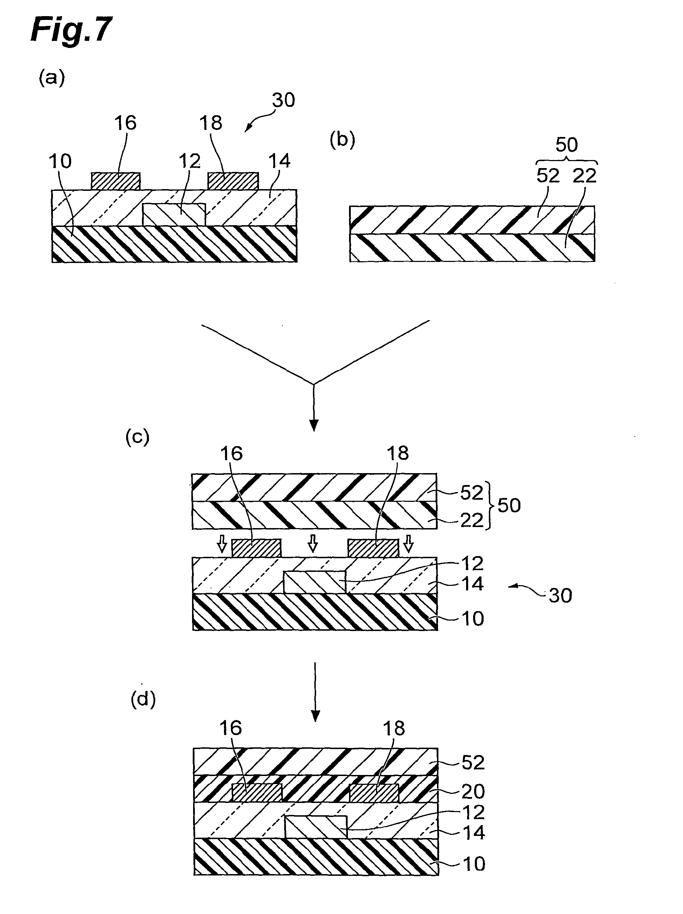

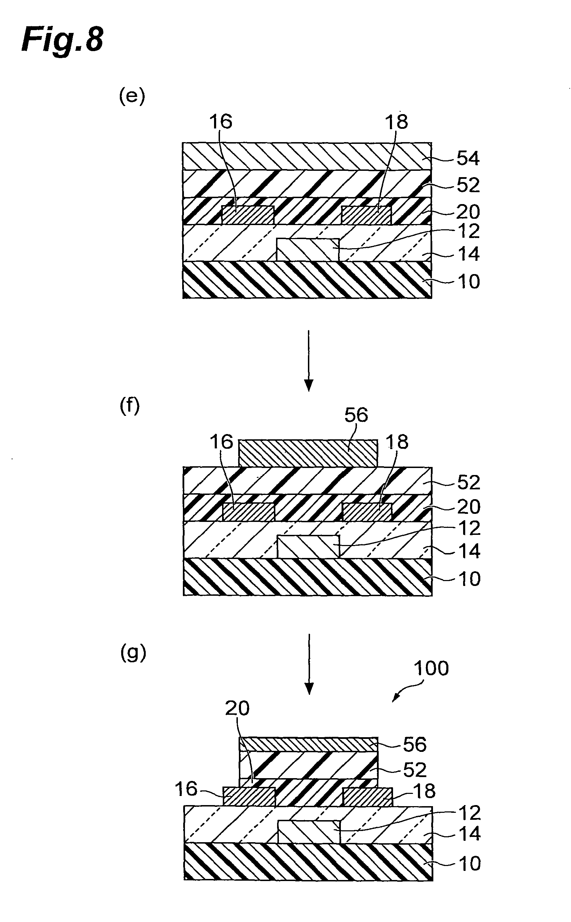

First, a process for producing the transistor of the first embodiment will be described. FIGs. 7 and 8 are process charts showing the process for producing a transistor according to the first embodiment. In this production method, first, an element substrate 30 is prepared, provided with a substrate 10, a gate electrode 12 formed above the substrate 10, an insulation layer 14 formed above the substrate 10 so as to cover the gate electrode 12, and a source electrode 16 and a drain electrode 18 formed above the insulation layer 14 (FIG 7 (a)). In the present embodiment, this element substrate 30 corresponds to the "element substrate on which an active layer will be disposed". In addition, separately from this, a layered body 50 is prepared, in which a support film 52 and a semiconductor film 22 that is to become an active layer 20 are layered (FIG 7 (b)).

As the substrate 10, one that does not disturb properties as a field effect transistor is used, and silicon substrates, glass substrates, plastic substrates and stainless foil substrates may be given. The insulation layer 14 is one comprising a material with high electrical insulating properties and, for instance, silicon oxide, silicon nitride, aluminum nitride, tantalum nitride, insulating polymer and the like can be used. Here, as insulating polymers, polyimide, poly(vinyl phenol), polyester, methacrylic resin, polycarbonate, polystyrene, valylene, and the like, may be cited.

The insulation layer 14 may have the surface thereof modified physically/chemically by a variety of methods. As physical modification methods, for instance, treatments by ozone UV and O₂ plasma may be cited. In addition, as chemical modification methods, for instance, treatment by a surface treatment agent such as silane coupling agent may be cited. As surface treatment agents, alkyl chlorosilanes, alkylalkoxysilanes, fluorinated alkyl chlorosilanes, fluorinated alkylalkoxysilanes, silyl amine compounds such as hexamethyl disilazane, and the like, may be cited. This surface treatment can be carried out, for instance, by bringing the insulation layer 14 in contact with a solution or gas of the surface treatment agent described above, and cause the surface treatment agent to adsorb on the surface of the insulation layer 14. Prior to the surface treatment, the face of the insulation layer 14 where the surface treatment is to be carried out can also be treated with ozone UV or O₂ plasma.

As methods for forming the insulation layer 14 over the substrate 10, for instance, methods such as plasma CVD method, thermal deposition method, thermal oxidation method, anodizing method, spin-coating method, casting method, microgravure coating method, gravure coating method, bar coating method, roll coating method, wire bar coating method, dip coating method, spray coating method, screen printing method, flexo printing method, offset printing method and inkjet printing method may be cited. For instance, when the substrate 10 is a silicon substrate, the surface thereof may be oxidized to form an insulation layer 14 comprising silicon oxide.

The gate electrode 12, source electrode 16 and drain electrode 18 are constituted by conductive materials. As conductive materials, metals such as aluminum, gold, platinum, silver, copper, chromium, nickel and titanium, conductive oxides such as ITO, and conductive polymers such as mixed polymer of poly(3,4-ethylenedioxythiophene) and polystyrene sulfonate, may be given as examples. In addition, a conductive material with metal microspheres, carbon black or graphite fine powder dispersed in a binder, is also adequate.

The thicknesses of the source electrode 16 and the drain electrode 18 are not limited in particular. However, when forming an active layer above the source electrode 16 or the drain electrode 18 as in the present embodiment or the second, third and fifth embodiments described below, it is desirable that the source electrode 16 and the drain electrode 18 are as thin as possible, to the extent that the functions thereof as electrodes are not lost, in order to render adhesion with the active layer more satisfactory.

The element substrate 30 having the above constitution can be produced by well known transistor production method and, for instance, methods described in US Patent Specification No. 6107117 can be applied.

Meanwhile, the layered body 50 is formed by layering over the support film 52 a semiconductor film 22 that is to become an active layer 20. The support film 52 may be one comprising any of an inorganic material and an organic material. For instance, polysiloxane, fluorine series resin, polyethylene, polypropylene, methylpentene resin, polycarbonate, polyimide, polyamide, polyvinyl chloride, vinylidene chloride, acrylic resin, methacrylic resin, polystyrene, nylon, polyester, polyvinyl alcohol, and the like, can be given as examples. In addition, the support film 52 may be one having functions as a photoresist. For instance, one comprising polyvinyl alcohol containing a photo-sensitive agent, or one in which the layer of polyvinyl alcohol containing the photo-sensitive agent is layered on the outer-most surface on the opposite side from the semiconductor film 22 may be cited.

Meanwhile, the semiconductor film 22 may be one constituted by an organic semiconductor compound alone, or may be one further containing an additive constituent other than the organic semiconductor compound. As organic semiconductor compounds, small molecule organic semiconductor compounds and polymer organic semiconductor compounds may be cited.

As additive constituents of the semiconductor film 22, dopants, adjusting materials to adjust the carrier in the active layer 20, polymer materials to elevate the mechanical properties of the semiconductor film, and the like, may be cited. Note that the semiconductor film 22 may be one containing a plurality of types of organic semiconductor compounds or a plurality of types of additive constituents. As organic semiconductor compounds, polymer organic semiconductor compounds are more desirable than small molecule organic semiconductor compounds from the point of view of obtaining satisfactory membrane-forming properties. In addition, the semiconductor film 22 for forming the active layer 20 may be constituted by single crystals of these compounds.

Here, as small molecule organic semiconductor compounds or polymer organic semiconductor compounds, for instance, the compounds indicated below as examples may be given respectively. Note that in the organic semiconductor element of the present invention, the organic semiconductor compound contained in the active layer 20 is not necessarily limited to those indicated below as examples.

As small molecule organic semiconductor compounds, polyacene compounds such as anthracene, tetracene, pentacene, benzopentacene, dibenzopentacene, tetrabenzopentacene, naphthopentacene, hexacene, heptacene and nanoacene; phenanthrene, picene, fulminene, pyrene, anthanthrene, peropyrene, coronene compounds such as coronene, benzocoronene, dibenzocoronene, hexabenzocoronene, benzodicoronene and vinylcoronene; perylene compounds such as perylene, terylene, diperylene and quaterrylene; trinaphthene, heptaphene, ovalene, rubicene, violanthrone, isoviolanthrone, chrysene, circum anthracene, bisanthene, zethrene, heptazethrene, pyranthrene, violanthene, isoviolanthene, biphenyl, triphenylene, terphenyl, quaterphenyl, circobiphenyl, kekulene, phthalocyanine, porphyrin, fullerenes (C60, C70), tetrathiofulvalene compounds, quinone compounds, tetracyanoquinodimethane compounds, oligomers of polythiophene, oligomers of polypyrrole, oligomers of polyphenylene, oligomers of polyphenylenevinylene, oligomers of polythyenylenevinylene, copolymeric oligomers of thiophene and phenylene, copolymeric oligomers of thiophene and fluorene, and the like, may be cited. In addition, it is also possible to use derivatives of these small molecule organic semiconductor compounds. As such, for instance, there are rubrene, which is a benzene ring addition derivative of tetracene, and the like. In addition, carbon nanotubes, which extend the conjugated system of fullerenes, and the like, can also be given as examples.

In addition, as polymer organic semiconductor compounds, polythiophene, polyphenylene, polyaniline, polyphenylenevinylene, polythyenylenevinylene, polyacetylene, polydiacetylene, polytriphenyl amine, copolymer of triphenyl amine and phenylenevinylene, copolymer of thiophene and phenylene, copolymer of thiophene and fluorene, and the like, may be cited. In addition, it is also possible to use derivatives of these polymer organic semiconductor compounds. As such, for instance, poly(3-hexylthiophene), which is an alkyl-substituted polythiophene, and the like, can be given as examples.

In particular, as polymer organic semiconductor compounds, those having structures such as those described below can be given as examples, concretely.

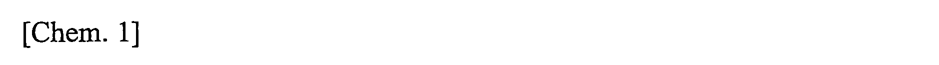

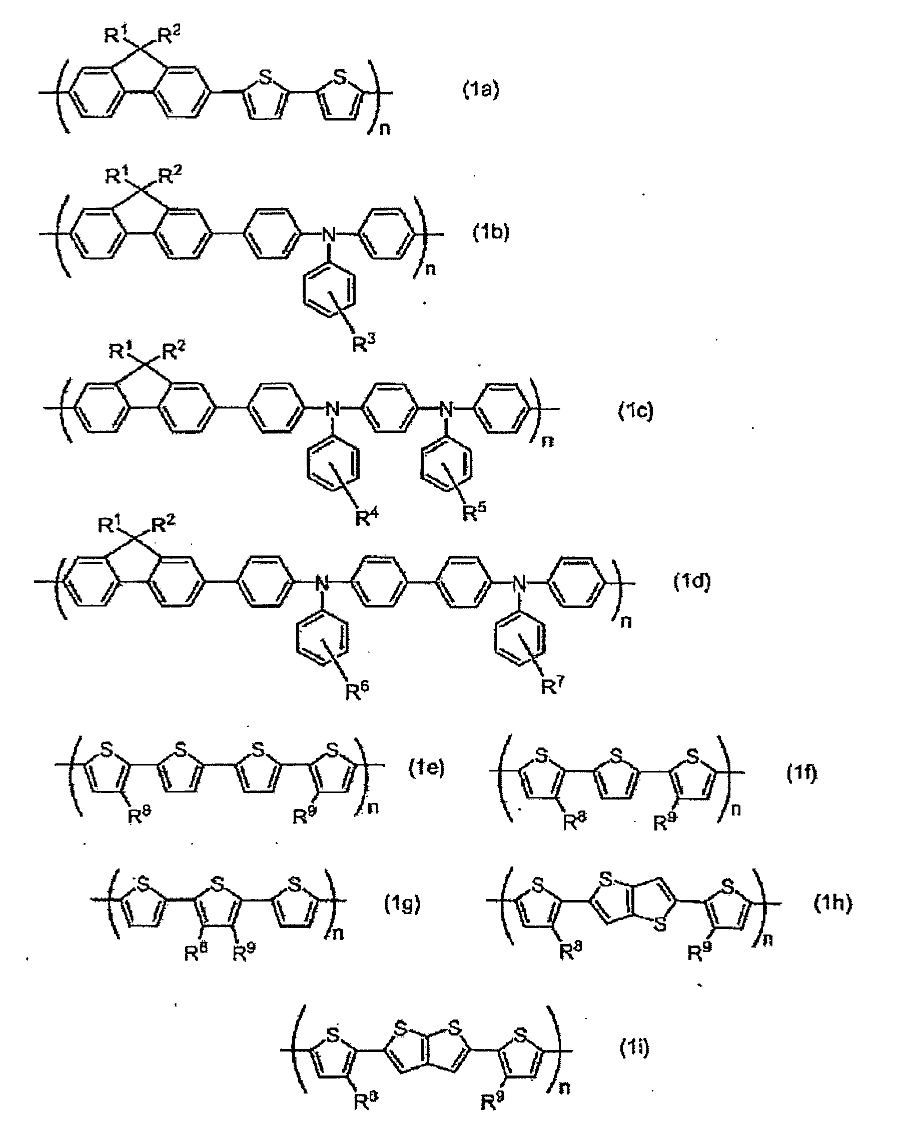

In the formulae (1a) to (1i), R¹, R², R³, R⁴, R⁵, R⁶, R⁷, R⁸ and R⁹ each independently represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a monovalent heterocyclic group, a halogen atom or a cyano group. n is an integer equal to or greater than 1.

As dopants, which are additive constituents other than the organic semiconductor compound, acceptor dopant and donor dopants may be cited.

First, as acceptor dopants, halogens such as iodine, bromine, chlorine, iodine chloride and iodine bromide; sulfur oxide compounds such as sulfuric acid, anhydrous sulfuric acid, sulfur dioxide and sulfates; nitrogen oxide compounds such as nitric acid, nitrogen dioxide and nitrates; halogenated compounds such as perchloric acid and hypochlorous acid; acids such as tetrafluoroboric acid, tetrafluoroborate, phosphoric acid, phosphate and trifluoroacetic acid or salts thereof; tetracyanoquinodimethane, tetrachlorotetracyanoquinodimethane, tetrafluorotetracyanoquinodimethane, tetracyanoethylene, dichlorocyanoethylene, dichlorodicyanoquinone, tetrachloroquinone, carbon dioxide, oxygen, and the like, can be given as examples.

In addition, as donor dopants, tetrathiafulvalene, tetramethyltetrathiafulvalene and tetraselenathiafulvalene; amine compounds such as diphenylphenylenediamine, tetraphenylphenylenediamine, tetraphenyldiaminodiphenyl and polyvinylcarbazole; alkali metals, alkaline earth metals, rare earth metals, and complexes of these metals with organic compounds, and the like, can be given as examples.

Elsewhere, as adjusting materials for adjusting the carrier in the active layer 20, materials having electric conductivity, for instance, transition metals such as aluminum, iron, copper, nickel, zinc, silver, platinum, gold and microparticles thereof may be cited.

In addition, as polymer material for elevating the mechanical properties of the semiconductor film 22, polycarbonate, polyacrylate, polymethyl acrylate, polymethyl metacrylate, polystyrene, polypolyvinyl chloride, polysiloxane, and the like, may be cited.

The layered body 50 can be formed for instance with the methods by direct addition of the organic semiconductor compound directly to the support film 52, by direct coating of a solution of organic semiconductor compound to the support film 52, or the methods by bonding of the support film 52 and the pre-formed semiconductor film 22.

Direct addition of an organic semiconductor compound to the support film 52 can be carried out, for instance, in the case of a solid organic semiconductor compound, by vapor deposition, spray coating of the melt, sublimation addition, or the like, of the organic semiconductor compound onto the support film 52. In addition, in case of a single crystal organic semiconductor compound, methods such as natural adhesion and bonding using an adhesive onto the support film 52 can be applied.

Direct coating of a solution of organic semiconductor compound onto the support film 52 can be carried out, for instance, by spin-coating method, casting method, microgravure coating method, gravure coating method, bar coating method, roll coating method, wire bar coating method, dip coating method, spray coating method, screen printing method, flexo printing method, offset printing method, inkjet printing method and the like. Note that in so doing, the surface of the support film 52 may be physically/chemically modified in order to adjust the wetting ability of the organic semiconductor compound with respect to the support film 52. For instance, oxygen plasma treatment may be cited as a physical modification method.

Meanwhile, when bonding the support film 52 and the semiconductor film 22, the semiconductor film 22 is produced first. In the production of the semiconductor film 22, the organic semiconductor compound, or, the organic semiconductor compound and an additive constituent other than this, is dissolved/dispersed in an organic solvent to obtain a solution. Then, this solution is coated over for instance a polytetrafluoroethylene resin plate, and then the organic solvent is volatilized. the layer formed in this way is peeled off from the polytetrafluoroethylene resin plate to obtain the semiconductor film 22.

As organic solvents used for the solution to produce the semiconductor film 22, chlorine series solvents such as chloroform, methylene chloride, dichloroethane and trichlorobenzene; ether series solvents such as tetrahydrofuran; aromatic hydrocarbon series solvents such as toluene, xylene, mesitylene, tetralin, decalin and n-butyl benzene; aromatic series solvents having an alkoxy group such as anisole, and the like, may be cited.

In addition, as solution coating methods, spin-coating method, casting method, microgravure coating method, gravure coating method, bar coating method, roll coating method, wire bar coating method, dip coating method, spray coating method, screen printing method, flexo printing method, offset printing method, inkjet printing method, and the like, can be given as examples.

Note that when the organic semiconductor compound is a thermoplastic material, the method of obtaining the semiconductor film 22 by heating and rolling once softened can also be cited.

Then, the semiconductor film 22 thus obtained and the support film 50 are bonded while heating as necessary and pressing or the like to obtain the layered body 50.

While a layered body 50 is obtained as described above, in a transistor having an active layer 20 containing an organic semiconductor compound, if this active layer 20 has an orientation, the characteristics of the transistor (carrier mobility) tends to improve since the molecules of the organic semiconductor compound become oriented in one direction. Consequently, it is desirable that the active layer 20 has undergone orientation treatment.

In order to obtain an active layer 20 oriented in this way, it is desirable that orientation is carried out prior to laminating to the element substrate 30, that is to say, at the stage of the semiconductor film 22 (layered body 50). As methods for orientation, first, the method of stretching the semiconductor film 22 may be cited. In this case, for instance, the semiconductor film 22 is stretched in the state of the layered body 50 along with the support film 52. As stretching methods, methods such as uniaxial stretching, biaxial stretching, in-solution swell-stretching, and stretching with rolls are given as examples.

Uniaxial stretching is a method whereby each of a pair of opposite edges of a semiconductor film 22 (layered body 50) in a square shape is clamped in a chuck, to pull in opposing directions and stretch. In so doing, pulling may be at room temperature, or pulling may be while heating to a suitable degree. In addition, pulling can also be carried out under specific gas atmosphere such as nitrogen gas.

In addition, biaxial stretching is a method whereby each of two pairs of opposing edges of a semiconductor film 22 (layered body 50) in a square shape is clamped in a chuck, to pull simultaneously or successively in the two opposing directions and stretch the film. In so doing, pulling may be at room temperature, or pulling may be while heating to a suitable degree. In addition, pulling can also be carried out under a specific gas atmosphere such as nitrogen gas.

In addition, in-solution swell-stretching is a method whereby the semiconductor film 22 (layered body 50) is immersed in a suitable solution in which the semiconductor film 22 swells without being dissolved, and pull and stretch the film therein by uniaxial stretching or biaxial stretching described above. In this case, pulling may be carried out at room temperature, or may be carried out while heating to a suitable degree.

Note that when performing such stretching, as the support film 52, one enabling such stretching is desirable, and concretely, polyethylene, polypropylene, methylpentene resin, polycarbonate, polyimide, polyamide, polyvinyl chloride, vinylidene chloride, methacrylic resin, nylon, polyester, polyvinyl alcohol and the like are preferred.

The element substrate 30 (FIG. 7 (a)) and the layered body 50 (FIG. 7 (b)) are obtained as described above.

In the present embodiment, the layered body 50 and the element substrate 30 are next laminated so that the semiconductor film 22 in the layered body 50 and the insulation layer 14 in the element substrate 30 are facing (laminating step; FIG. 7 (c)). It is desirable that laminating is carried out while heating and/or pressing. As concrete methods of such laminating, without particular limitation, for instance, first, the semiconductor film 22 in the layered body 50 is place over the insulation layer 14 where the source electrode 16 and the drain electrode 18 have been formed. Then, the semiconductor film 22 placed over the insulation layer 14 is heated and/or pressed causing adhesion to the insulation layer 14. This forms the active layer 20 from the semiconductor film 22.

Of heating and pressing in this laminating step, only either one may be performed or both may be performed. In addition, when both are carried out, heating and pressing may be performed simultaneously, or either one may be performed before and the other one performed after. In addition, in the laminating step, laminating may be performed under reduced pressure to improve adhesiveness further. In addition, when heating or the like is performed in air, sometimes undesirable changes in properties occur depending on the type of organic semiconductor compound, such as becoming oxidized. Thus, in addition to reduced pressure, it is possible to carry out the laminating step under nitrogen atmosphere, under shaded light, or in an environment where moisture, oxygen and the like are controlled, as necessary.

However, if heating and pressing are carried out at extreme conditions, there is the danger that alterations occur in properties of the semiconductor film 22 (for instance, orientation if it is oriented) or the like, and obtaining an active layer 20 having the desired properties becomes difficult. Consequently, it is desirable that heating and pressing are carried out at suitable conditions. As optimum heating condition, a temperature condition that is the room temperature or higher, to an extent that does not give rise to deformation in the semiconductor film 22, the insulation layer 14 laminating thereto, or the element substrate 30 and the like, may be cited. For instance, when the semiconductor film 22 comprises a polymer organic semiconductor compound, it is desirable that the temperature is the liquid crystal phase or the isotropic phase transition temperature thereof or lower. Meanwhile, when the semiconductor film 22 comprises a small molecule organic semiconductor compound, it is desirable that the temperature is the melting point thereof or lower. Note that even when the temperature exceed these, performing the heating is possible if for a short time and to an extent that does not give rise to the issues described above.

In addition, pressing is carried out in the direction in which the semiconductor film 22 and the insulation layer 14 are layered, and for instance, the load may be applied from the support film 52 side of the layered body 50, or a roll may be used to press the entire body. It is desirable that the pressure during pressing is to an extent that does not give rise to deformation or defect in the semiconductor film 22, the insulation layer 14 constituting the element substrate 30, the substrate 10, the source electrode 16 or the drain electrode 18.

In addition, in the laminating step, a prescribed mounting solution may be introduced between the semiconductor film 22 and the insulation layer 14. As the mounting solution, a liquiform substance (liquid) having the property of being able to wet both the insulation layer 14 and the semiconductor film 22 is used. The semiconductor film 22 and the insulation layer 14 are wetted satisfactory by this, allowing the adhesiveness of both parties to be improved further.

As the mounting solution, one for which the contact angle with the surface of insulation layer 14 where the active layer 20 is to be formed is 120 degrees or less is desirable, one with 90 degrees or less is more desirable, and one with 60 degrees or less is even more desirable. Here, when a droplet of mounting solution is formed on the insulation layer 14 in air, among the angles formed by the tangent line drawn from the contact point of these three phases to the mounting solution and the surface of the insulation layer 14, "contact angle" refers to the angle containing the mounting solution.

It is desirable that the preferred mounting solution is selected suitably according to the type of insulation layer 14 (contact angle with the insulation layer 14). For instance, when the surface of the insulation layer 14 is silicon oxide (SiO₂ or the like), silicon oxide modified with alkyl trichlorosilane (octadecyl trichlorosilane or the like), silicon nitride, organic series insulation membrane, or the like, as the mounting solution, alcohol series solvents having 1 to 8 carbons such as methanol, ethanol and isopropanol, ketone series solvents such as acetone, ether series solvents such as diethyl ether, halogen series solvents such as chloroform (more preferably ones in which an alcohol or the like has been mixed), aromatic hydrocarbon series solvents such as toluene (more preferably ones in which an alcohol or the like has been mixed), aliphatic hydrocarbon series solvents such as hexane, heptane and octane, water (more preferably, one containing a surfactant), nitrile series solvents such as acetonitrile, ester series solvents such as ethyl acetate, solvents containing an amine series compound such as aqueous ammonia, and the like, are desirable.

The mounting solution may further contain an additive such as a surfactant for adjusting the wetting ability with respect to the insulation layer 14, a dopant, which may adjust the transistor properties due to the active layer 20, a material for adjusting the carrier concentration in the active layer 20, and the like. Note that the above solvents as the mounting solution given as examples may be used alone, or two or more species may be used in combination.

As a method for introducing a mounting solution between the semiconductor film 22 and the insulation layer 14 to bond these, for instance, the method whereby a mounting solution is coated over the surface of one among the semiconductor film 22 and the insulation layer 14, and then the other is layered over this mounting solution may be cited. In addition, as other methods, a method whereby a space between the semiconductor film 22 and the insulation layer 14 is retained by opening a prescribed gap (space), and a mounting solution is injected into this gap, and the like, can also be given as examples. In these methods, if the mounting solution is, as described above, one for which the contact angle with the insulation layer 14 is 120 degrees or less, the surface of the insulation layer 14 can be wetted efficiently, allowing the laminating to be carried out all the more satisfactorily.

Note that when laminating is mediated by a mounting solution, it is performed in such a way that the entirety of the semiconductor film 22 does not become dissolved. This is because it is difficult to form a uniform active layer 20 if the entirety of the semiconductor film 22 is dissolved. Note that in the laminating, it suffices that the semiconductor film 22 is not dissolved in its entirety, and that there is no problem even if a partial dissolution occurs.

When a mounting solution is used, a removal step for removing unnecessary volatile constituents in this mounting solution may be carried out. This allows the adhesiveness between the semiconductor film 22 and the insulation layer 14 to be increased. Note that in this removal step, the mounting solution may be removed entirely or a portion may remain. For instance, if the adhesive properties between the insulation layer 14 and the active layer 20 is maintained satisfactorily, the entirely of the mounting solution may be removed.

By laminating the element substrate 30 and the layered body 50 in this way, a structure in which these have been adhered is obtained (FIG. 7 (d)). Thereafter, a photoresist solution is coated over the support film 52 in the laminated layered body 50 to form a photoresist layer 54 (FIG. 8 (e)).

As photoresist materials, for instance, photoresist materials such as polyvinyl alcohol, polystyrene and poly(methylmethacrylate) containing a reaction starter, which are used in the patterning of inorganic semiconductor materials such as silicon and gallium-arsenicum, can be applied with no particular limitation. Here, a reaction starter is one that allows a reaction for crosslinking the aforementioned polymer to be carried out by ultraviolet light or heat. In addition, aside from such solution coating, a photoresist layer 54 can also be formed, for instance, by bonding a pre-formed resist film.

Next, the photoresist layer 54 is patterned into a shape corresponding to a prescribed pattern that is to be formed on the active layer 20 to form a mask layer 56 (FIG. 8 (f)). For instance, the method of photolithography used for the patterning of inorganic semiconductor materials, or the like, may also be applied to this patterning.

Note that, as methods for forming the mask layer 56, aside from the method of photolithography, the method may be for forming a mask layer 56 having the desired pattern directly, such as, methods whereby a masking material is vapor-deposited directly through a mask having an aperture of the desired size such as a metal mask, and methods using an ink comprising a masking material dissolved or dispersed in a solvent or the like to carry out drop-casting, inkjet, printing or the like.

When forming the mask layer 56, a protective layer (not illustrated) may be formed between the support film 50 and the mask layer 56 as a protection of the active layer 20. As protective layers, layers comprising organic materials such as parylene and polyvinyl alcohol, or inorganic materials such as silicon nitride, silicon oxide, silicon carbide and aluminum nitride may be cited. Layers comprising parylene can be formed by vapor deposition (for instance, Labcoater; Parylene Japan KK), layers comprising silicon nitride, silicon oxide, silicon carbide, aluminum nitride, or the like, can be formed by the CVD method or the sputter method, and layers comprising polyvinyl alcohol can be formed by preparing an aqueous solution thereof and carrying out coating method such as the spin-coating method. Note that when a protective layer is formed, patterning is carried out so that this protective layer is etched or the like into an equivalent pattern to mask layer 56.

Thereafter, by carrying out etching through the mask layer 56 formed in this way to remove the layered body 50 (support film 52 and active layer 20), and as necessary the protective layer, in regions not covered by this mask layer 56, the active layer 20 is patterned to have the same pattern shape as the mask layer 56 (FIG. 8 (g)).

As methods for etching, dry etching and wet etching may be cited. For instance, as dry etching, etching by oxygen plasma, or the like, may be cited. Note that when etching the active layer 20, sometimes the mask layer 56 is also etched, diminishing the thickness thereof, such that it is conceivable that the mask layer 56 disappears during the etching. Therefore, it is desirable that the mask layer 56 retains a thickness that allows a prescribed thickness to be obtained even after completion of the etching. However, since the support film 52 above the active layer 20 can also function as a protective layer against etching, if the support film 52 is one that can retain a thickness that is sufficient for protection against etching, the mask layer 56 may be removed in its entirety by etching.

Through the steps such as those described above, a transistor 100 of the first embodiment provided with the active layer 20 having a prescribed pattern shape is obtained. Note that in the transistor 100, the mask layer 56 after etching may be left as-is as a layer for the protection of the active layer 20 and the like, or may be removed by a resist removal solution or etching, should it be necessary. In addition, the support film 50 remaining above the active layer 20, as necessary, may be removed or may be left as-is.

### (Process for producing the transistor of the second embodiment)

A preferred process for producing the transistor of the second embodiment will be described below.

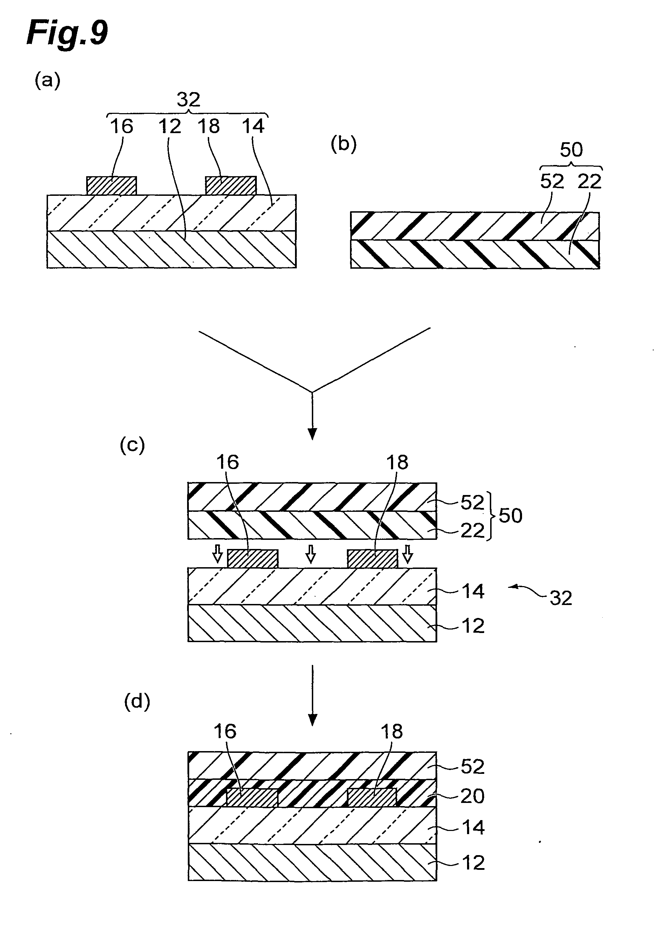

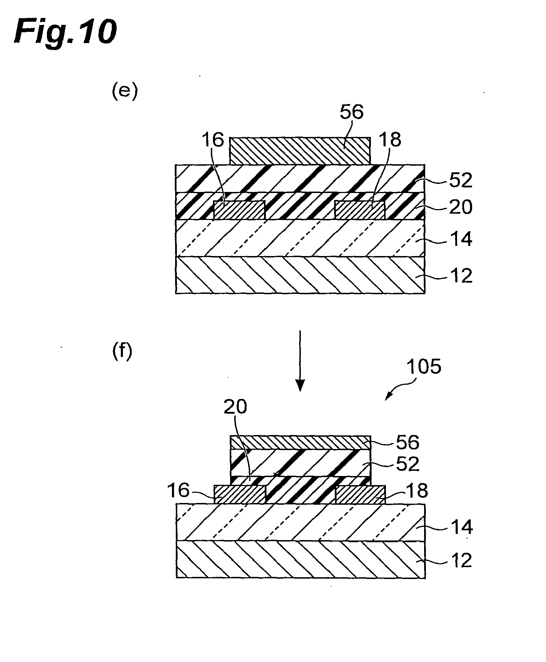

FIGs. 9 and 10 are process charts showing the process for producing a transistor of a second embodiment. In this production method, first, an element substrate 32 is prepared, comprising a gate electrode 12, an insulation layer 14 formed above the gate electrode 12, and a source electrode 16 and a drain electrode 18 formed above the insulation layer 14 (FIG. 9 (a)). Here, the gate electrode 12 is one that combines also the functions of a substrate. As such a gate electrode 12, metal substrates such as for instance, heavily doped silicon or aluminum, and the like, are desirable. The insulation layer 14 and the source and drain electrodes 16 and 18 can be formed similarly to the first embodiment described above.

In addition, along with the production of the element substrate 32, a layered body 50 is prepared, in which a support film 52 and a semiconductor film 22 that is to become an active layer 20 are layered, similarly to the first embodiment (FIG 9 (b)). Then, the laminating step for laminating the layered body 50 and the element substrate 32 is carried out (FIG. 9 (c)) to obtain a structure in which the layered body 50 is layered over the element substrate 32 (FIG. 9 (d)).

In the second embodiment, after the laminating step, a mask layer 56 having the same pattern shape as the shape to be formed in the active layer 20 is formed above the support film 52 provided above the active layer 20 (FIG. 10 (e)). Then, through this mask layer 56, the layered body 50 (support film 52 and active layer 20) is selectively removed in regions not covered by the mask layer 56 to pattern the active layer 20 into the same shape as the mask layer 56 (FIG 10 (f)). The series of steps from the laminating step to patterning in the second embodiment can also be performed similarly to the first embodiment described above. A transistor 105 of the second embodiment obtained in this way.

### (Process for producing the transistor of the third embodiment)

A process for producing the transistor of the third embodiment will be described below.

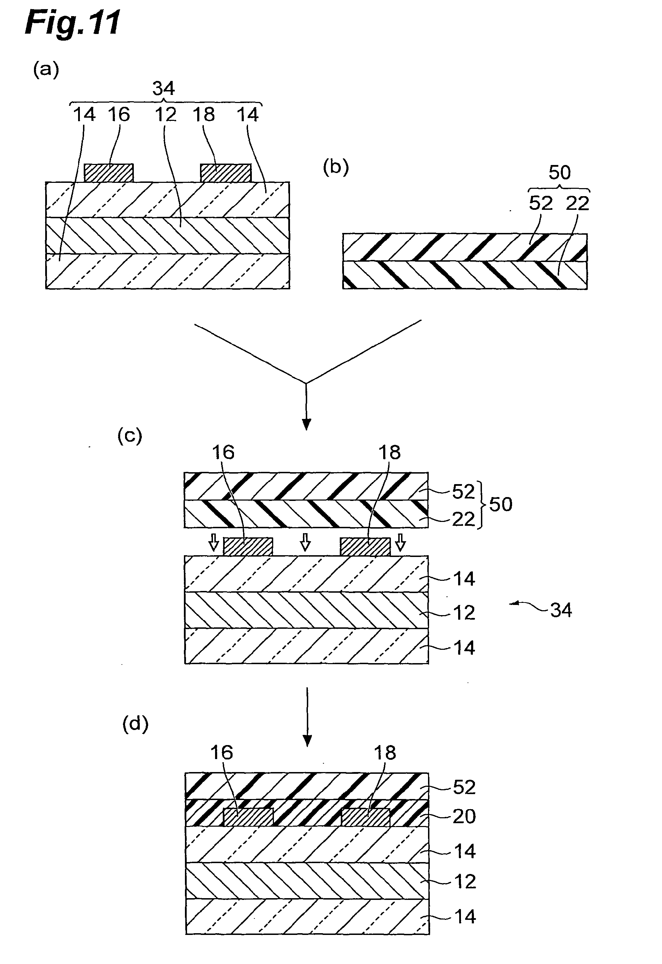

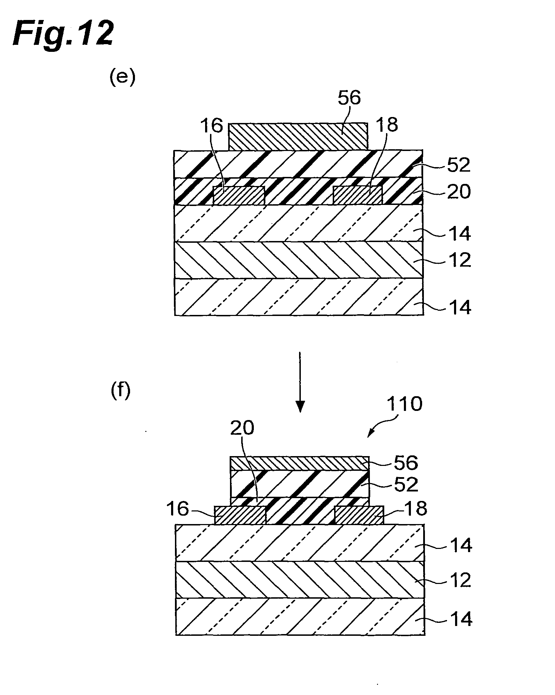

FIGs. 11 and 12 are process charts showing the process for producing a transistor according to a third embodiment. In this production method, first, an element substrate 34 is prepared, comprising a gate electrode 12, insulation layers 14 formed on both faces of the gate electrode 12, a source electrode 16 and a drain electrode 18 formed above one insulation layer 14 (FIG 11 (a)). In addition, separately from this, a layered body 50 similar to that in the first embodiment is prepared (FIG. 11 (b)). Note that the insulation layer 14, the source electrode 16 and the drain electrode 18 in the element substrate 34 can be formed similarly to the first embodiment described above.

In the present embodiment, as shown in FIG. 11 (c), the element substrate 34 and the layered body 50 are laminated next; however, prior to this, similarly to the first embodiment, it is desirable to orient the semiconductor film 22 in the layered body 50. Note that the orientation can also be carried out by methods other than the stretching described above.

For instance, when the organic semiconductor compound constituting the semiconductor film 22 has liquid crystallinity, in addition to stretching, orientation of the semiconductor film 22 may be carried out by other methods known as orientation techniques for liquid crystals. As such methods, for instance, methods such as those described in "Basics And Applications Of Liquid Crystals (Ekisho No Kiso To Oyo)" (Sheiichi Matsumoto and Shiryou Kakuta Co-authors, Kogyo Chosakai, 1991) Chapter 5, "Structures And Properties Of Ferroelectric Liquid Crystals (Kyoindenseiekisho No Kozo To Bussei)" (Atsuo Fukuda and Hideo Takezoe Co-authors, Corona, 1990) Chapter 7, "Liquid Crystals" Volume 3, No. 1 (1999) pp. 3 to 16, and the like, may be cited.

Concretely, orientation methods such as, for instance, rubbing method, photo-alignment method, shearing method (shearing stress application method) and pull-up coating method are simple and useful, and are particularly easy to employ.

The rubbing method is a method whereby the support film 52 is lightly rubbed with a cloth or the like. As clothes for rubbing the support film 52, clothes such as gauze and polyester, cotton, nylon and rayon can be used. The cloth to be used for rubbing can be selected suitably according to the film to be oriented. In this case, if a separate alignment film is formed above the support film 52 above, the orientation capability becomes higher. As this alignment film, polyimide, polyamide, polyvinyl alcohol, polyester, nylon and the like may be cited, and commercial alignment films for liquid crystals can also be applied. The alignment film can be formed by the spin-coating method or flexo printing and the like.

In addition, photo-alignment method is a method whereby an alignment film is formed above the support film 52, and an alignment function is conferred by polarized UV light illumination or by illuminating a UV light obliquely. As alignment films, polyimide, polyamide, polyvinylcinnamate and the like can be cited, and commercial alignment films for liquid crystals can also be applied.

The organic semiconductor compound (semiconductor film 22) layered over the support film 52 treated as described above can be oriented by such rubbing method or photo-alignment method. This orientation is generated by causing the organic semiconductor compound to be at the temperature of the liquid crystal phase or the isotropic phase, above the support film 52. In addition, the semiconductor film 22 formed above the support film 52 can also be oriented by providing the organic semiconductor compound above the support film 52 after the orientation treatment has been performed.

In addition, when coating organic a semiconductor compound over the support film 52, orientation can also be generated by placing the organic semiconductor compound above the support film 52 above, with a setting at the Tg (glass transition point) thereof or higher, or at a temperature where a liquid crystal phase or an isotropic phase is shown, and carrying out coating in one direction with a rod or the like. In addition, a solution comprising an organic semiconductor compound dissolved in an organic solvent may be prepared and this may be coated by spin-coating, flexo printing or the like. Note that even when the organic semiconductor compound does not have liquid crystallinity, if it is one that allows for vapor deposition, a layer comprising an oriented organic semiconductor compound (semiconductor film 22) can be obtained by epitaxially vapor-depositing this organic semiconductor compound above the orientation-treated support film 52.

In addition, the shearing method is a method whereby a different substrate is placed above the organic semiconductor compound placed above the support film 52, and the upper substrate is shifted in one direction under a temperature where the organic semiconductor compound becomes a liquid crystal phase or an isotropic phase. In so doing, as the support film 52, if one having a support layer that has undergone an orientation treatment such as those described in the rubbing method and the photo-alignment method described above is used, a semiconductor film 22 having a higher degree of orientation is obtained. As the upper substrate, glass, polymer film and the like can be cited, and this may also be a rod made of metal or the like.

In addition, the pull-up coating method is a method whereby the support film 52 is immersed into a solution of organic semiconductor compound and pulled up to form a layer of oriented organic semiconductor compound (semiconductor film 22) above the support film 52 above. There are no particular limitations on conditions such as the organic solvent used in the solution of organic semiconductor compound and the support film 52 pull-up speed, which are preferably selected and adjusted according to the desired degree of orientation of the organic semiconductor compound.

Although a number of orientation methods for the semiconductor film 22 have been described, from the points of view of convenience and usefulness it is particularly desirable to carry out orientation by stretching.

Next, similarly to the first embodiment, a laminating step is carried out, whereby the element substrate 34 and the layered body 50 prepared as described above are laminated in such a way that the insulation layer 14 in the element substrate 34 and the semiconductor film 22 in the layered body 50 are in contact (FIG 11 (c) to (d)).

Then, after the laminating step described above has been performed, a mask layer 56 having a pattern shape corresponding to that to be formed in the active layer 20 is formed by a photolithographic method or the like above the support film 52 of the layered body 50 (FIG. 12(e)). Then, by carrying out etching or the like through this mask layer 56, the active layer 20 (and support film 52) is patterned so as to have the same pattern shape as the mask layer 56 (FIG 12(f)). These steps can be performed similarly to the first embodiment. In this way, a transistor 110 according to the third embodiment is obtained.

### (Process for producing the transistor of the fourth embodiment)

Next, a process for producing the transistor of the fourth embodiment will be described.

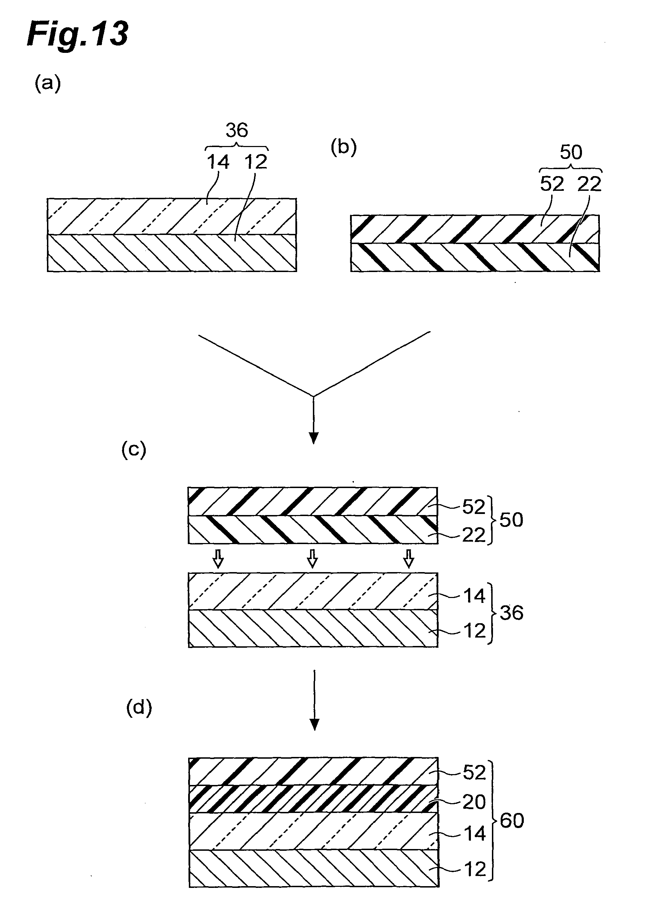

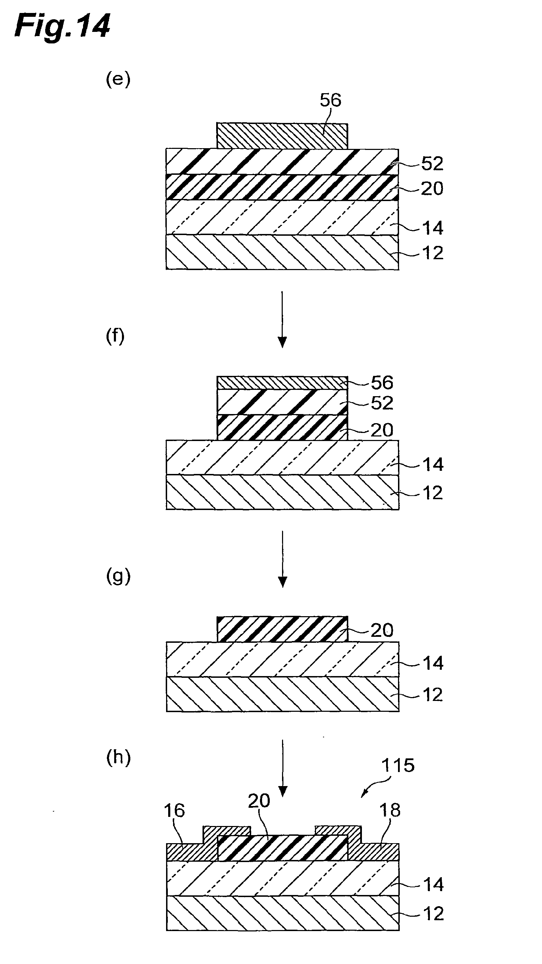

FIGs. 13 and 14 are process charts showing the process for producing a transistor of the fourth embodiment. In this production method, first, a first element substrate 36 is prepared, comprising a gate electrode 12 and an insulation layer 14 formed thereabove (FIG. 13(a)). This gate electrode 12 is one that combines functions as a substrate. The constitutions and production methods for the gate electrode 12 and the insulation layer 14 can be carried out similarly to the second embodiment or the like.

In addition, along with the first element substrate 36, a layered body 50 is prepared, in which a support film 52 and a semiconductor film 22 that is to become an active layer 20 are layered (FIG. 13(b)). Thereafter, a laminating step is carried out, whereby the first element substrate 36 and the layered body 50 are laminated (FIG. 13(c)). This laminating step can also be performed similarly to the first embodiment or the like, and is carried out in such a way that the insulation layer 14 in the first element substrate 36 and the semiconductor film 22 in the layered body 50 are in tight contact. This yields a second element substrate 60 in which the gate electrode 12, the insulation layer 14, the active layer 20 comprising the semiconductor film 22, and the support film 52 are layered in this order (FIG. 13(d)).

Next, a mask layer 56 having a pattern shape corresponding to the one to be formed in the active layer 20 is formed by a photolithographic method or the like above the support film 52 of the second element substrate 60 (FIG. 14 (e)). Then, by carrying out etching or the like through this mask layer 56, the active layer 20 is patterned so as to have the same pattern shape as the mask layer 56 (FIG 14(f)). These steps can be performed similarly to the first embodiment.

Then, after removal of the mask layer 56 and the support film 52 has been carried out by etching or the like (FIG. 14(g)), a source electrode 16 and a drain electrode 18 are formed above the insulation layer 14 so as to cover portions of the patterned active layer 20 (FIG. 14(h)). This allows a transistor 115 according to the fourth embodiment to be obtained.

### (Process for producing the transistor of the fifth embodiment)

Next, a preferred process for producing the transistor of the fifth embodiment will be described.

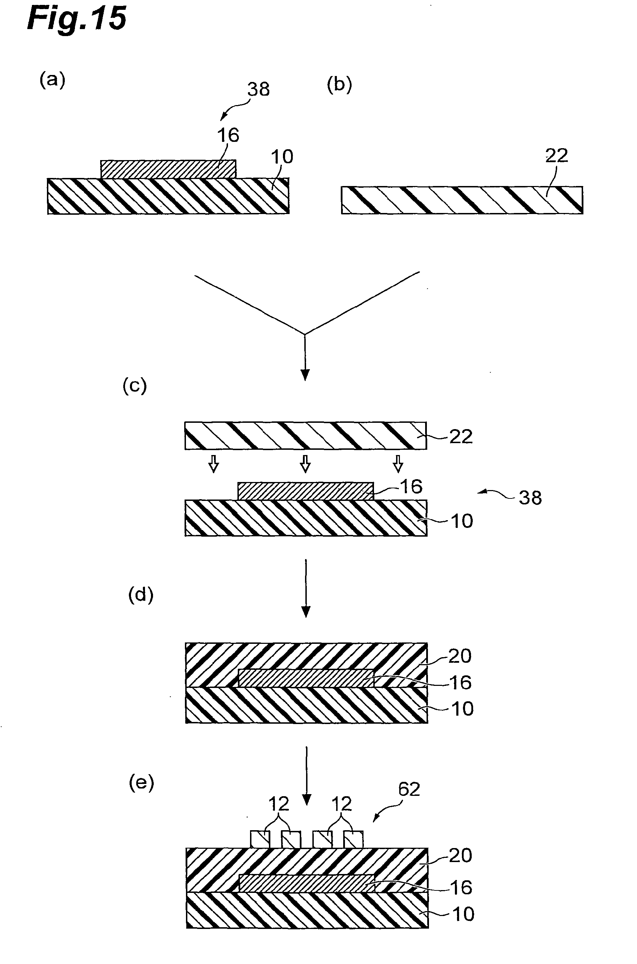

FIGs. 15, 16 and 17 are process charts showing the process for producing a transistor of the fifth embodiment. In this production method, first, a first element substrate 38 is prepared; provided with a substrate 10 and a source electrode 16 formed thereabove (FIG. 15(a)). In addition, separately from this, a semiconductor film 22 that is to become an active layer 20 is prepared (FIG. 15(b)). As the semiconductor film 22, the one formed in the production step of the layered board 50 in the description of the first embodiment described above can be applied. Then, a first laminating step is carried out, whereby the semiconductor film 22 is laminated against the first element substrate 38 so as to cover the gate electrode 16 (FIG. 15(c)). This forms an active layer 20 above the first element substrate 38 (FIG. 15(d)).

Next, a plurality of (here, four) gate electrodes 12 are formed above the active layer 20 formed above the first element substrate 38, which yields a second element substrate 62 (FIG 15(e)). As these gate electrodes 12, similar ones to that in the first embodiment or the like can also be applied.

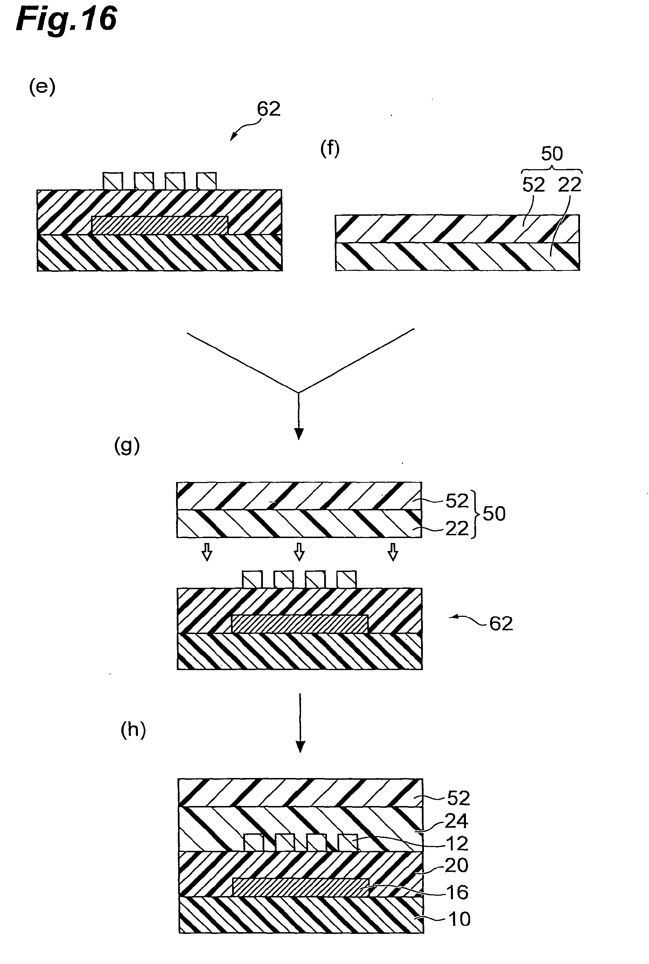

In addition, along with this second element substrate 62 (FIG. 16(e)), a layered body 50 is prepared, in which a support film 52 and a semiconductor film 26 are layered (FIG. 16(f)). The organic semiconductor compound constituting this semiconductor film 26 may be the same one as the active layer 20 in the first element substrate 38, or may be a different one.

Next, a second laminating step is carried out, whereby the layered body 50 and the second element substrate 62 are laminated in such a way that the semiconductor film 26 in the layered body 50 and the active layer 20 in the second element substrate 62 are facing (FIG. 16(g)). This adheres the semiconductor film 26 in the layered body 50 on top of the active layer 20 of the second element substrate 62 so as to cover the gate electrode 12 to form an active layer 24 (FIG. 16(h)).

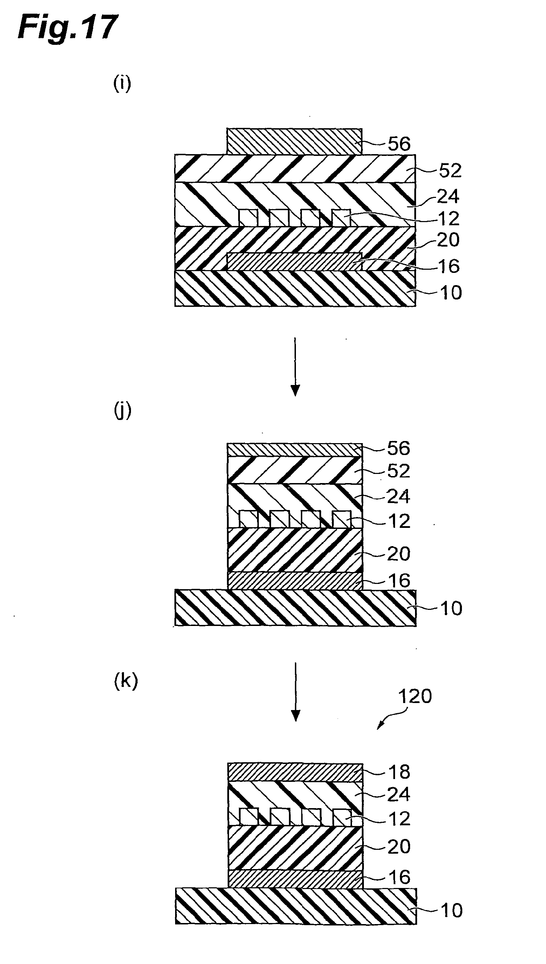

Next, a mask layer 56 having a pattern shape corresponding to the one to be formed in the active layer 20 is formed above the support film 52 in the laminated layered body 50 (FIG. 17(i)). Then, by carrying out etching or the like through this mask layer 56, the active layer 20 and the active layer 24 are patterned so as to have the same pattern shape as the mask layer 56 (FIG. 17(j)). This patterning can also be performed similarly to the first embodiment.

Then, after removing the mask layer 56 and the support film 52, a drain electrode 18 is formed above the active layer 24 similarly to the first embodiment or the like (FIG. 17(k)). This allows a transistor 120 according to the fifth embodiment to be obtained.

Note that in this process for producing the transistor of the fifth embodiment, either one of the active layers 20 and 24 may also be formed according to the methods described, for instance, in Japanese Patent Application Laid-open No. 2004-006476. In addition, in the first laminating step, instead of the semiconductor film 22, the layered body 50 (layered body comprising the support film 52 and the semiconductor film 22) such as described above may be used. However, in this case, the support film 52 is removed from the active layer 20 to perform the subsequent steps.

### (Process for producing the transistor of the sixth embodiment)

Next, a preferred process for producing the transistor of the sixth embodiment will be described.

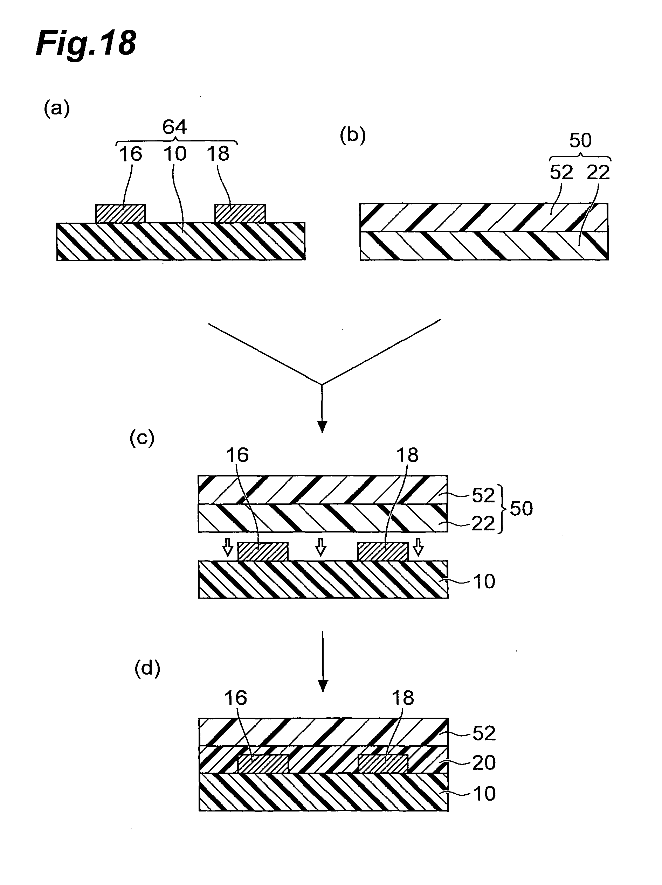

FIGs. 18, 19 and 20 are process charts showing the process for producing a transistor of the sixth embodiment. In this production method, first, an element substrate 64 is prepared, provided with a substrate 10, and a source electrode 16 and a drain electrode 18 thereabove (FIG. 18(a)). In addition, a layered body 50 is prepared, in which a semiconductor film 22 that is to become an active layer 20 and a support film 52 are layered (FIG. 18(b)). Next, a laminating step is carried out, whereby the layered body 50 and the element substrate 64 are laminated in such a way that the semiconductor film 22 and the source and drain electrodes 16 and 18 are facing (FIG 18(c)). This forms an active layer 20 above the element substrate 64 so as to cover the source electrode 16 and the drain electrode 18 (FIG 18(d)).

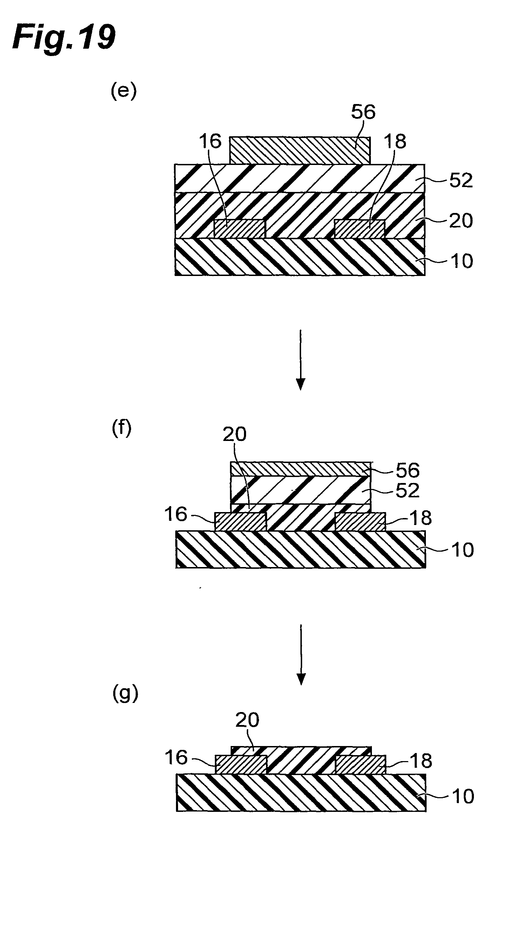

Next, a mask layer 56 having a pattern shape corresponding to the one to be formed in the active layer 20 is formed above the support film 52 in the laminated layered body 50 (FIG. 19(e)). Then, by carrying out etching or the like through this mask layer 56, the active layer 20 is patterned so as to have the same pattern shape as the mask layer 56 (FIG. 19(f)). Thereafter, the mask layer 56 and the support film 52 that remain above the active layer 20 are removed by etching or the like (FIG. 19(g)).

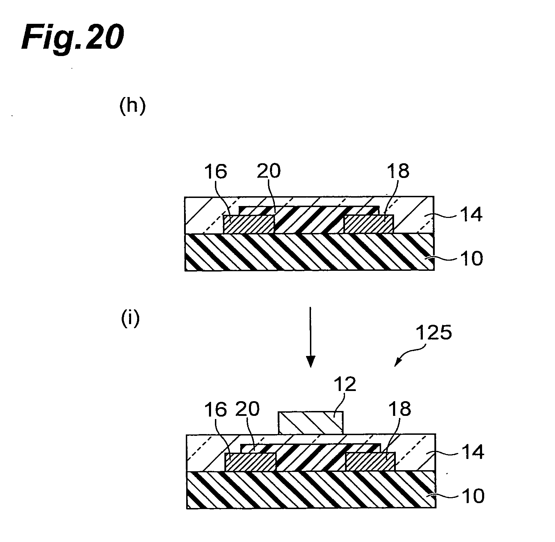

Thereafter, an insulation layer 14 is formed above the patterned active layer 20, similarly to the first embodiment or the like (FIG. 20(h)). Then, a gate electrode 12 is formed above the insulation layer 14 thereby allowing a transistor 125 of the sixth embodiment to be obtained (FIG. 20(i)).

Note that, in the production of the transistor of the sixth embodiment, after patterning, removal of the mask layer 56 and the support film 52 was carried out; however, when these are ones that combine functions as insulation layer 14, they may be left as-is without being removed as part of the insulation layer 14, and these may be used as the insulation layer 14 as-is.

Regarding the transistors of the first to sixth embodiment and the production methods therefor above, the following variations are possible.

First, the active layer 20 (active layers 20 and 24 for the fifth embodiment) in the transistor of each embodiment does not need to be one comprising a single layer, and may be one comprising a plurality of layers. When the active layers 20 and 24 are ones comprising a plurality of layers, these may be ones constituted from the same material, or may be ones constituted from different materials. The active layers 20 and 24 comprising a plurality of layers can be formed by layering sequentially a plurality of semiconductor films 22 and 26 while removing suitably the support film 52 and the like.

In addition, the insulation layer in the transistor of each embodiment does also not need to be one comprising respectively a single layer, and may be one comprising a plurality of layers. When the insulation layer comprises a plurality of layers, these may be ones constituted from the same material, or may be ones constituted from different materials. Similarly, the protective layer formed in the transistor, does not need to be one comprising a single layer, and may be one comprising a plurality of layers formed from identical or different materials.

In addition, the embodiments described above all had structures in which the source electrode 16 and the drain electrode 18 are in direct contact with the active layers 20 and 24; however, without limiting to this, a layer comprising a compound different from the organic semiconductor compound may be inserted between the source electrode 16 and/or the drain electrode 18 and the active layers 20 and 24. This sometimes allows the contact resistance between the source electrode 16 and the drain electrode 18, and the active layers 20 and 24 to be decreased, further increasing the carrier mobility of the transistor. As compounds constituting such a layer, donor compounds, acceptor compounds, compounds having a thiol group, and the like, may be cited.

Here, as donor compounds, tetrathiafulvalene, tetramethyltetrathiafulvalene and tetraselenathiafulvalene; amine compounds such as diphenylphenylenediamine, tetraphenylphenylenediamine, tetraphenyldiaminodiphenyl and polyvinylcarbazole; alkali metals, alkaline earth metals, rare earth metals, and complexes of such metals with organic compounds, and the like, may be cited.

In addition, as acceptor compounds, halogens such as iodine, bromine, chlorine, iodine chloride and iodine bromide; sulfur oxide compounds such as sulfuric acid, anhydrous sulfuric acid, sulfur dioxide and sulfates; nitrogen oxide anhydrides such as nitric acid, nitrogen dioxide and nitrates; halogenated compounds such as perchloric acid and hypochlorous acid; acids such as tetrafluoroboric acid, tetrafluoroborate, phosphoric acid, phosphate and trifluoroacetic acid or salts thereof; tetracyanoquinodimethane, tetrachlorotetracyanoquinodimethane, tetrafluorotetracyanoquinodimethane, tetracyanoethylene, dichlorocyanoethylene, dichlorodicyanoquinone, tetrachloroquinone, and the like, may be cited.

In addition, as compounds having a thiol group, alkylthiol compounds such as alkylthiols and fluorinated alkylthiols, aromatic thiols, fluorinated alkyl aromatic thiols, fluorinated aromatic thiols, nitro aromatic thiols and amino aromatic thiols, and the like, may be cited.

A layer comprising these compounds can be formed, for instance, by bringing a solution or a gas of a compound described above in contact with the surface of the source electrode 16 or the drain electrode 18 to adsorb the compound to this contact surface.

In addition, when forming such active layers 20 and 24 as described above, after the patterning process, the active layer may be subjected to heat treatment, as necessary. Carrying out such heat treatment sometimes allows a reversible damage to be repaired, which has occurred in the active layer due to the mask layer formation process or the patterning process, for instance, a plasma damage or the like due to plasma process.

Note that in all the production methods for the transistors of the embodiments described above, patterning is carried out by forming the active layer 20 or the active layer 24 using the layered body 50 and then forming the mask layer 56 above the support film 52; however in the present invention, there is no absolute need for using the layered body 50, and the active layers 20 and 24 may be formed by laminating the semiconductor film 22 alone. In this case, the mask layer 56 is formed directly above the active layers 20 and 24 and not above the support film 52 as described previously.

In other words, the production method for the organic semiconductor element of the present invention (transistor) having such a morphology is one comprising the step of laminating a semiconductor film and an element substrate for forming an active layer to form an active layer comprising a semiconductor film above the element substrate, the step of forming a mask having a prescribed pattern on the surface on the opposite side from the element substrate in the active layer, and the step of patterning the active layer by removing the active layer in the regions where the mask has not been formed.

The transistor of each embodiment described can be turned into an encapsulated transistor by carrying out encapsulation after completing such element construction as described above. This, in addition to shielding the transistor from air, protects it from physical damages and the like, allowing a decrease in the properties of the transistor to be suppressed.

As methods for encapsulation, methods whereby the element construction is covered with an insulating polymer, a UV-curing resin, a heat-curing resin, an inorganic silicon oxide film, a silicon nitride film or the like, methods whereby a glass plate or a film is bonded with a UV-curing resin, a heat-curing resin or the like, against the element construction, and the like, may be cited. In order to carry out effectively shielding against air, after the transistor has been fabricated, it is desirable to carry our the steps until encapsulation without exposure to air (for instance, kept in dried nitrogen atmosphere or in vacuum).

Thus, transistors and production methods thereof have been described as one example of the organic semiconductor element of the present invention and production method thereof; however, the organic semiconductor elements in which the present invention is applied are not limited to transistors as long as they are ones having an active layer containing an organic semiconductor compound. As organic semiconductor elements other than transistor, for instance, diode, photodiode, solar batteries, light-emitting diodes, memories, light-emitting transistors, sensors, and the like, may be cited.

Then, the organic semiconductor element obtained by the present invention equips a variety of semiconductor devices. As semiconductor devices equipped with the organic semiconductor element, wireless tags, displays, large-area sensors, and the like, may be cited. In these semiconductor devices, for instance, a transistor, alone or in a plurality of combinations with other transistors, can constitute a logical circuit. Concretely, it is suitable as a transistor for pixel switching on a semiconductor device display, a signal driver circuit element, a memory circuit element, a signal processing circuit element, and the like. As displays, a wide range of application is possible, such as electronic paper, liquid crystal or organic LED.

### Examples

Hereinafter, the present invention will be described in further detail with examples; however, the present invention is not limited to these examples.

### [Organic semiconductor compound]

For the poly(3-hexylthiophene) and poly(3-dodecylthiophene) used in the each example below, those purchased from Aldrich were used. In addition, for poly(3-hexylthiophene) and poly(3-dodecylthiophene), regioregular ones were used.

### [Example 1]

### (Production of transistor)

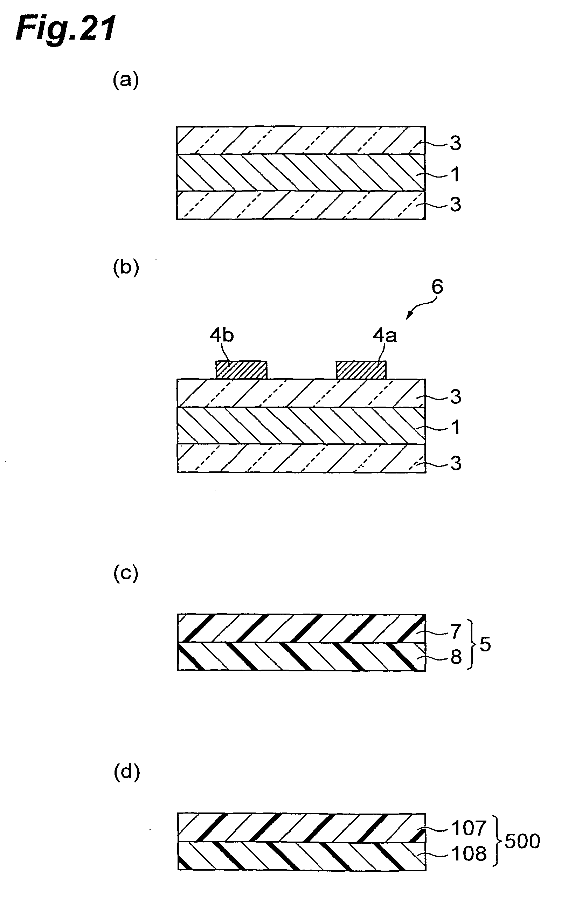

In the following, a transistor was produced according to the process for producing a transistor of the third embodiment. FIGs. 21, 22 and 23 are figures showing the process for producing the transistor of Example 1. First, as shown in FIG 21 (a), a heavily doped n-type silicon substrate 1 was prepared, which is to become the gate electrode doubling as a substrate, and the surface thereof was thermally oxidized to form 200 nm of a silicon oxide film, which is to become an insulation layer 3. Then, as shown in FIG 21(b), on the surface of the insulation layer 3 on one side of this substrate 1, gold was vapor deposited to a thickness of 50 nm by the vacuum deposition method to form a source electrode 4a and a drain electrode 4b having a lead-out wire and a pad. At this time, the channel width of the electrode was 500 µm and the channel length was 40 µm.

Thereafter, the substrate after electrode formation was immersed in a solution of octyl trichlorosilane in octane (6 mmol/l) according to methods described in the literature (S. R. Wasserman, et al., Langmuir, Vol.5, p 1074, 1989) to modify the surface of the insulation layer 3. In addition, the obtained substrate was immersed in a solution of 4-(trifluoromethyl)thiophenol in ethanol (1 mmol/L) to modify the surfaces of the source electrode 4a and the drain electrode 4b. This formed an element substrate 6.

Meanwhile, inside a glove box with nitrogen atmosphere, a solution of poly(3-hexylthiophene) in chlorobenzene (3wt%) was prepared. However, weighing of poly(3-hexylthiophene) was carried out in air. Then, inside the glove box with nitrogen atmosphere, the solution of poly(3-hexylthiophene) in chlorobenzene was coated by the spin-coating method over a poly(1-methylpentene) film, which is a support film 7, of which the surface was treated by oxygen plasma. This formed a layered body 5 in which, as shown in FIG. 21(c), a poly(3-hexylthiophene) film, which is a semiconductor film 8, is layered over the polyethylene support film 7.

Subsequently, this layered body 5 was subjected to stretching operation to produce a stretched layered body 500 in which a stretched support film 107 and a stretched semiconductor film 108 are layered (FIG. 21(d)). The stretching operation was carried out after formation of the layered body 5, by uniaxially stretching this four-fold under nitrogen atmosphere at 175°C.

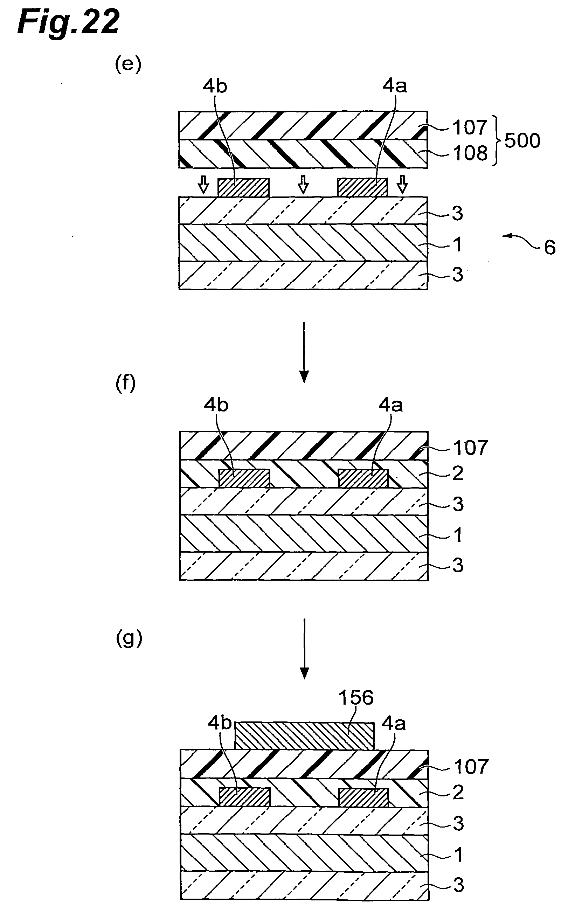

Thereafter, the stretched layered body 500 and the element substrate 6 were bonded inside the glove box with nitrogen atmosphere, as shown in FIG. 22(e). Laminating was carried in such a way that the semiconductor film 108 and the source electrode 4a and drain electrode 4b were facing, and by introducing the mounting solution acetonitrile between these. In so doing, the stretched layered body 500 was aligned in such a way that the stretching direction thereof was parallel to the direction that joins the source electrode 4a and the drain electrode 4b in the element substrate 6. Then, by leaving to stand still until acetonitrile was dried and removed, the stretched layered body 500 was brought naturally in tight contact with the element substrate 6. Then, in order to remove acetonitrile further, heat treatment was carried out under nitrogen atmosphere at 80°C for one hour. This yielded a transistor provided with a layer 2 comprising poly(3-hexylthiophene) which was not patterned (FIG. 22 (f)). The obtained transistor was referred to as "pre-patterning transistor".

Thereafter, under nitrogen atmosphere, an aqueous solution of polyvinyl alcohol was coated over the support film 107 in the transistor described above, so as to obtain a prescribed pattern. Then, by heat treatment at 80°C for one hour, the solution of polyvinyl alcohol was dried to form a mask layer 156 having a prescribed pattern (FIG. 22(g)).

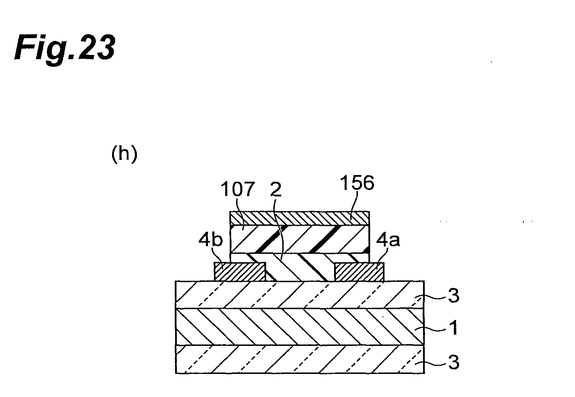

Then, by carrying out etching by oxygen plasma with this mask layer 156 as the mask, the support film 107 and the active layer 2 were patterned so they had a prescribed pattern shape. Then, after patterning, by carrying out heat treatment at 80°C × two hours under nitrogen atmosphere, a transistor was obtained, provided with the active layer 2 comprising poly(3-hexylthiophene) having a prescribed pattern (FIG. 23(h)). The obtained transistor was referred to as "post-patterning transistor".

### (Evaluation of transistor properties)

First, the transistor properties of the "pre-patterning transistor" obtained in the preparation process of transistor described above were measured as described in the following. That is to say, the transistor properties were measured under nitrogen atmosphere by applying 40 to -60 V gate voltage V_{G} and -60 V source-drain voltage V_{SD} to the "pre-patterning transistor" with the silicon substrate 1 as the gate electrode. The mobility obtained from this I-V characteristic was 1.7 × 10⁻¹ cm²/Vs, and the on-off ratio of the current was 6 × 10⁶.

In addition, transistor properties of the "post-patterning transistor" were evaluated. That is to say, transistor properties were measured under nitrogen atmosphere, by applying respectively 40 to -60 V gate voltage V_{G} and -60 V source-drain voltage V_{SD} to the "post-patterning transistor" with the silicon substrate 1 as the gate electrode. The mobility obtained from this I-V characteristic was 1.1 × 10⁻¹ cm²/Vs, and the on-off ratio of the current was 0.6 × 10⁶.

### [Example 2]

### (Production of transistor)

In Example 2, with the exception of the points of modification below, a transistor was produced, provided with an active layer comprising poly(3-dodecylthiophene), by performing similar processes to Example 1. That is to say, the points of modification from the Example 1 were: (a) channel length was 200 µm instead of 40 µm, (b) after the formation of the source electrode 4a and the drain electrode 4b, these were treated with 4-(trifluoromethyl)thiophenol, (c) as forming material of semiconductor film 8, a solution of poly(3-dodecylthiophene) in chloroform was used instead of a solution of poly(3-hexylthiophene) in chlorobenzene, (d) the support film 7 was changed to polyethylene film which was not oxygen plasma treated instead of poly(1-methylpentene) film, (e) the conditions for the stretching operation of the layered body 5 was changed to 5-fold uniaxial stretching at 100°C instead of 4-fold uniaxial stretching at 175°C, (f) during formation of the mask layer 156, drying of the solution of polyvinyl alcohol was carried out by heat treatment at 70°C for one hour instead of 80°C for one hour, and (g) heat treatment after patterning was carried out at 70°C for one hour instead of 80°C for two hours.

### (Evaluation of transistor properties)

First, under nitrogen atmosphere, 40 to -40 V gate voltage V_{G} and -40 V source-drain voltage V_{SD} were applied to the "pre-patterning transistor" obtained by the production methodo of Example 2, with the silicon substrate 1 as the gate electrode, to measure the transistor properties thereof. The mobility obtained from this I-V characteristic was 4.3 × 10⁻² cm²/Vs and the on-off ratio of the current was 1.0 × 10⁻⁵.

In addition, under nitrogen atmosphere, 40 to -40 V gate voltage V_{G} and -40 V source-drain voltage V_{SD} were applied to the "post-patterning transistor" with the silicon substrate 1 as the gate electrode to measure the transistor properties thereof. The mobility obtained from this I-V characteristic was 3.7 × 10⁻² cm²/Vs and the on-off ratio of the current was 4.8 × 10⁻⁴.

### [Comparative Example 1]

### (Production of transistor)

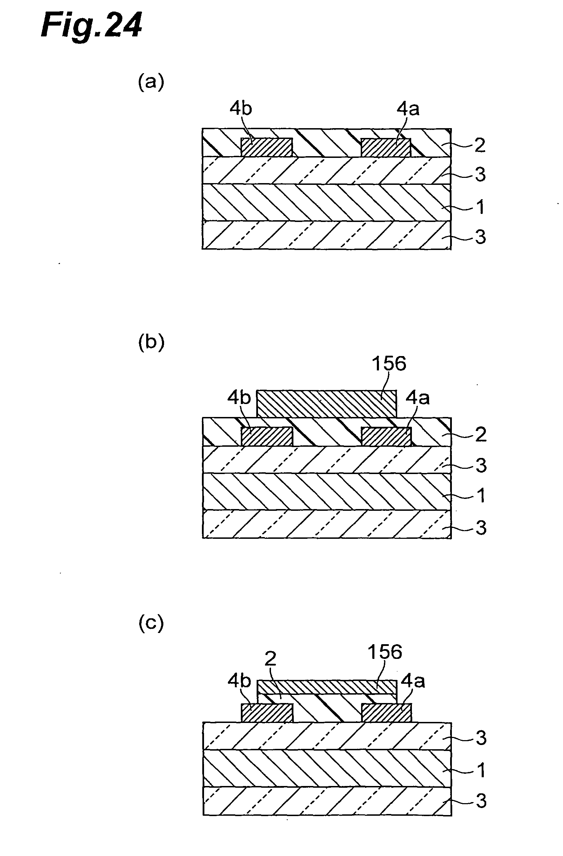

FIG. 24 is a figure showing the process for producing the transistor of Comparative Example 1. First, production up to the element substrate 6 was carried out similarly to Example 2. In addition, a solution of poly(3-dodecylthiophene) in toluene (0.1wt%) was prepared inside a glove box with nitrogen atmosphere. However, weighing of poly(3-dodecylthiophene) was carried out in air.

Then, inside the glove box with nitrogen atmosphere, the solution of poly(3-dodecylthiophene) in toluene was cast over the surface provided with the source electrode 4a and the drain electrode 4b of the element substrate 6. This yielded a transistor provided with an active layer 2 comprising poly(3-dodecylthiophene) which has not been patterned (FIG. 24 (a)). The obtained transistor was the "pre-patterning transistor".

Next, under nitrogen atmosphere, as shown in FIG. 24(b), an aqueous solution of polyvinyl alcohol was directly coated over the active layer 2 so as to have a prescribed pattern to form a mask layer 156. Thereafter, patterning using the mask layer 156 as the mask was carried out similarly to Example 2 to produce a transistor provided with an active layer 2 comprising poly(3-hexylthiophene) having a prescribed pattern (FIG. 20(c)). The obtained transistor was the "post-patterning transistor".

### (Evaluation of transistor properties)

First, under nitrogen atmosphere, 40 to -40 V gate voltage V_{G} and -40 V source-drain voltage V_{SD} were applied to the "pre-patterning transistor" obtained in the process for producing the transistor of Comparative Example 1, with the silicon substrate 1 as the gate electrode, to measure the transistor properties thereof. The mobility obtained from this I-V characteristic was 8.0 × 10⁻³ cm²/Vs and the on-off ratio of the current was 1 × 10⁻⁵.

In addition, under nitrogen atmosphere, 40 to -40 V gate voltage V_{G} and -40 V source-drain voltage V_{SD} were applied to the "post-patterning transistor" with the silicon substrate 1 as the gate electrode to measure the transistor properties thereof. The mobility obtained from this I-V characteristic was 2.0 × 10⁻⁴ cm²/Vs and the on-off ratio of the current was 9.6 × 10⁻³.

## Claims

1. A method for producing an organic semiconductor element having an active layer comprising a semiconductor film containing an organic semiconductor compound, the method comprising:
the step of laminating a layered body resulting from lamination of a support film and the active layer to an element substrate on which the active layer will be disposed so that the active layer of the layered body will be in contact with the element substrate,
the step of forming a mask having a prescribed pattern shape on the support film's surface located on the side opposite to the active layer, and
the step of patterning the active layer by removing the layered body located in a region where the mask has not been formed.

2. The method for producing an organic semiconductor element according to Claim 1, further comprising the step of orienting the active layer in the layered body before laminating the layered body to the element substrate.

3. The method for producing an organic semiconductor element according to Claim 1 or 2, wherein the mask is one formed directly on the support film's surface located on the side opposite to the active layer by applying a solution containing a material for forming the mask.

4. The method for producing an organic semiconductor element according to any one of Claims 1 to 3, wherein the organic semiconductor element is a transistor comprising a source electrode, a drain electrode, the active layer to serve as a current pathway between the electrodes, and a gate electrode that controls the amount of current passing through the current pathway.

5. An organic semiconductor element obtainable by the production method according to any one of Claims 1 to 4.

6. A semiconductor device comprising the organic semiconductor element according to Claim 5.
